# EUROPEAN PATENT APPLICATION

(11) **EP 2 166 411 A2**
(43) Date of publication of application: **24.03.2010**
(21) Application number: 09170519.4
(22) Date of filing: 17.09.2009
(51) Int. Cl.: G03F 7/031, B41C 1/10, G03F 7/32

(54) **Lithographic printing plate precursor, process for producing lithographic printing plate, and lithographic printing plate**

(30) Priority: 18.09.2008 JP 2008239947
(71) Applicant: Fujifilm Corporation, Minato-ku Tokyo (JP)
(72) Inventor: Oohashi, Hidekazu, Shizuoka (JP)
(74) Representative: HOFFMANN EITLE

(57) **Abstract**

A lithographic printing plate precursor is provided that has above a support a photosensitive layer containing at least a polymerizable compound, a photopolymerization initiator, a binder polymer, and at least one compound, represented by any of Formulae (1) to (5), having at least one hydrophilic group, a molecular weight of no greater than 1,500, a dipole moment of at least 3.8 Debye, and a Log P value of less than 1. 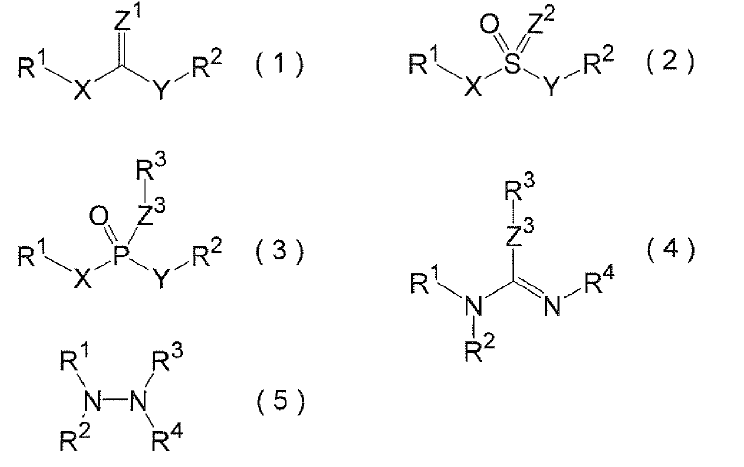 (In Formulae (1) to (5), X and Y independently denote a single bond, an oxygen atom, a sulfur atom, -C(R⁵)(R⁶)-, or -N(R⁵)-, Z¹ denotes an oxygen atom or a sulfur atom, Z² denotes an oxygen atom or a Ione electron pair, Z³ denotes a single bond, an oxygen atom, a sulfur atom, -C(R⁵)(R⁶)-, or -N(R⁵)-, and R¹ to R⁶ independently denote a monovalent substituent comprising at least one type of atom selected from the group consisting of a hydrogen atom, a carbon atom, an oxygen atom, a nitrogen atom, a sulfur atom, a phosphorus atom, a halogen atom, and a silicon atom, any two or more of R¹ to R⁶ may be bonded to each other to form a ring, or R¹ to R⁶ may form a double bond together with X, Y, or Z³.) There are also provided a process for producing a lithographic printing plate that includes an exposure step of imagewise exposing with a laser the lithographic printing plate precursor and a development step of removing the photosensitive layer of a non-exposed portion in the presence of an aqueous developer having a pH of 2 to 11, and a lithographic printing plate produced by the process for producing a lithographic printing plate.

## Description

The present invention relates to a lithographic printing plate precursor, a process for producing a lithographic printing plate, and a lithographic printing plate.

A lithographic printing plate conventionally comprises a photosensitive resin layer provided on a support having a hydrophilic surface. As for the plate-making method thereof, a desired printing plate is usually obtained by surface exposure (mask exposure) via a lith film and then removal of the non-image area with a developer. However, with the recent progress of digitization techniques, a computer-to-plate (CTP) technique of direct exposure on the plate surface by scanning according to digitized image data with highly directional light, for example, a laser beam, without using a lith film has been developed. Photosensitive lithographic printing plates (lithographic printing plate precursors) adapted for the technique have also been developed.

As the lithographic printing plate precursors suitable for exposure with a laser beam, lithographic printing plate precursors having a polymerizable photosensitive layer can be cited. In the polymerizable photosensitive layer, it is easy to increase the sensitivity by selecting a polymerization initiator or a polymerization initiation system (hereinafter also simply referred to as an 'initiator' and an 'initiation system', respectively) in comparison with other conventional photosensitive layers.

As the laser light source, for example, a semiconductor laser of 405 nm or 830 nm or an FD-YAG laser can be used. In recent years, a CTP system equipped with a semiconductor laser of 405 nm has become widespread in view of the system cost and the handling properties.

In the conventionally known plate-making process for a lithographic printing plate precursor, after the exposure as described above, a step of removing unnecessary image recording layer by dissolving, for example, with a developer is required. However, it is one of the objects to eliminate or simplify such an additional wet treatment. In particular, since disposal of liquid waste discharged accompanying wet treatment has become a great concern throughout the industrial field from the viewpoint of consideration for the global environment in recent years, the demand for a solution to the above-mentioned problem has been increasing more and more.

On the other hand, as a simple production process, there can be cited simple development processing employing an aqueous solution having a pH of no greater than 11.

For example, in U.S. Patent Application Publication No. 2004/0013968 there is described a processing method for a lithographic printing plate precursor that comprises preparing a lithographic printing plate precursor comprising (i) a hydrophilic support and (ii) an oleophilic heat-sensitive layer that contains a radically polymerizable ethylenically unsaturated monomer, a radical polymerization initiator and an infrared absorbing dye, is cured with infrared laser exposure and is developable with an aqueous developer containing 60 wt % or more of water and having a pH of 2.0 to 10.0, imagewise exposing the lithographic printing plate precursor with an infrared laser, and removing the uncured region of the heat-sensitive layer with the aqueous developer.

JP-A-11-249291 describes a negative-working photosensitive resin composition comprising a film-forming polymer, a radically polymerizable ethylenic double bond-containing unsaturated compound, a photopolymerization initiator, a thermal polymerization inhibitor, and a compound having a functional group selected from an alkoxy group, a carboxylic acid group, a sulfonic acid group, an amide group, a sulfonamide group, etc.

JP-A-2008-158444 describes a polymerizable composition comprising a binder polymer having a functional group with a dipole moment of at least 3.8 Debye, a radically polymerizable compound, and a radical polymerization initiator.

JP-A-2007-293223 describes a simple development type lithographic printing plate precursor comprising a polyfunctional polymerizable compound linked by ionic bonding, the lithographic printing plate precursor having excellent developability and plate life.

It is an object of the present invention to provide a lithographic printing plate precursor of a type that can be processed by simple development with a non-strongly alkaline aqueous solution (pH 2 to 11), the lithographic printing plate precursor having high sensitivity and excellent developability, staining resistance, and plate life, a process for producing a lithographic printing plate using same, and a lithographic printing plate.

The object of the present invention has been attained by means described in <1> to <10> below.
<1> A lithographic printing plate precursor having provided above a support a photosensitive layer comprising at least a polymerizable compound, a photopolymerization initiator, a binder polymer, and at least one compound, represented by any of Formulae (1) to (5), having at least one hydrophilic group, a molecular weight of no greater than 1,500, a dipole moment of at least 3.8 Debye, and a Log P value of less than 1, 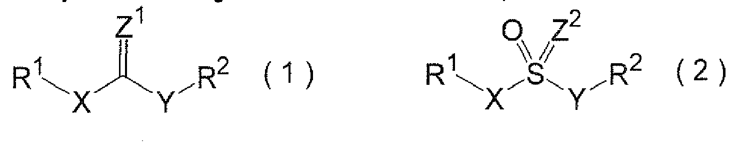 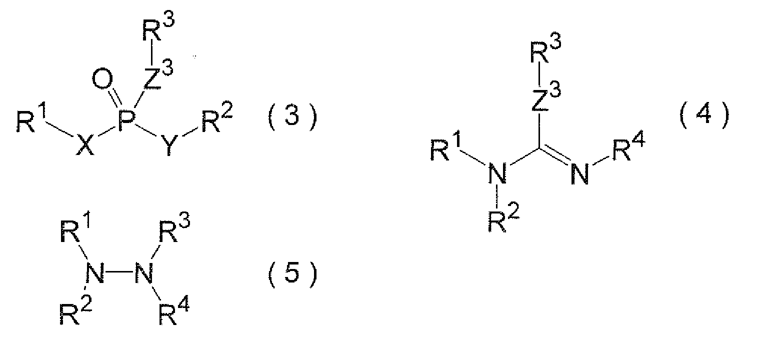 (in Formulae (1) to (5), X and Y independently denote a single bond, an oxygen atom, a sulfur atom, -C(R⁵)(R⁶)-, or -N(R⁵)-, Z¹ denotes an oxygen atom or a sulfur atom, Z² denotes an oxygen atom or a lone electron pair, Z³ denotes a single bond, an oxygen atom, a sulfur atom, -C(R⁵)(R⁶)-, or -N(R⁵)-, and R¹ to R⁶ independently denote a monovalent substituent comprising at least one type of atom selected from the group consisting of a hydrogen atom, a carbon atom, an oxygen atom, a nitrogen atom, a sulfur atom, a phosphorus atom, a halogen atom, and a silicon atom, any two or more of R¹ to R⁶ may be bonded to each other to form a ring, or R¹ to R⁶ may form a double bond together with X, Y, or Z³),
<2> The lithographic printing plate precursor according to <1>, wherein the hydrophilic group is selected from the group consisting of an acid group, an amide group, an alkylene oxide group, an ammonium group, a hydroxy group, and a sulfonamide group,
<3> The lithographic printing plate precursor according to <1> or <2>, wherein the compound represented by Formulae (1) to (5) above has a dipole moment of at least 4.0 Debye,
<4> The lithographic printing plate precursor according to any one of <1> to <3>, wherein the compound represented by Formulae (1) to (5) above has a Log P value of less than 0.75,
<5> The lithographic printing plate precursor according to any one of <1> to <4>, wherein the photosensitive layer further comprises a sensitizing dye,
<6> The lithographic printing plate precursor according to any one of <1> to <5>, wherein it comprises a protective layer above the photosensitive layer,
<7> A process for producing a lithographic printing plate, comprising an exposure step of imagewise exposing with a laser the lithographic printing plate precursor according to any one of <1> to <6>, and a development step of removing the photosensitive layer of a non-exposed portion in the presence of an aqueous developer having a pH of 2 to 11,
<8> The process for producing a lithographic printing plate according to <7>, wherein it comprises, subsequent to the exposure step and prior to the development step, a step of heating the lithographic printing plate precursor to 100°C or greater,
<9> The process for producing a lithographic printing plate according to <7> or <8>, wherein the development step is a step of carrying out using a single liquid removal of the protective layer, development, and a gumming treatment,
<10> A lithographic printing plate produced by the process for producing a lithographic printing plate according to any one of <7> to <9>,

In accordance with the present invention, there can be provided a lithographic printing plate precursor of a type that can be processed by simple development with a non-strongly alkaline aqueous solution (pH 2 to 11), the lithographic printing plate precursor having high sensitivity and excellent developability, staining resistance, and plate life, a process for producing a lithographic printing plate using same, and a lithographic printing plate.

### Brief Description of Drawings

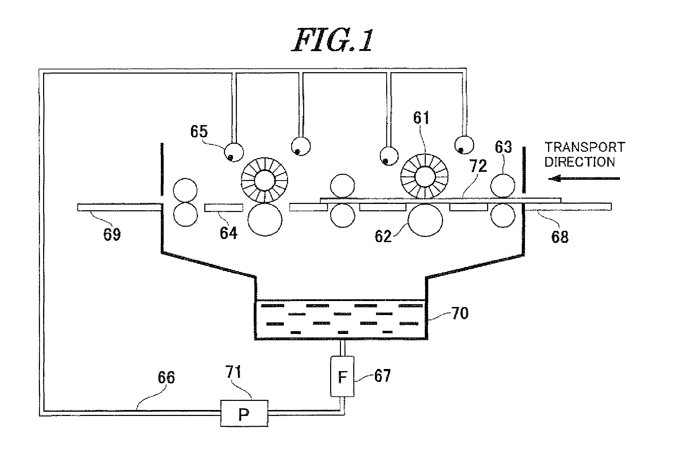

FIG. 1 is an explanatory diagram showing the structure of an automatic development processor.

### Explanation of Reference Numerals and Symbols

- 61: Rotating brush roller
- 62: Backing roller
- 63: Transport roller
- 64: Transport guide plate
- 65: Spray pipe
- 66: Pipeline
- 67: Filter
- 68: Plate supply table
- 69: Plate discharge table

- 70: Developer tank
- 71: Circulating pump
- 72: Plate

The present invention is explained in detail below.

### I. Lithographic printing plate precursor

The lithographic printing plate precursor of the present invention has provided above a support a photosensitive layer comprising at least a polymerizable compound, a photopolymerization initiator, a binder polymer, and at least one compound, represented by any of Formulae (1) to (5), having at least one hydrophilic group, a molecular weight of no greater than 1,500, a dipole moment of at least 3.8 Debye, and a Log P value of less than 1. 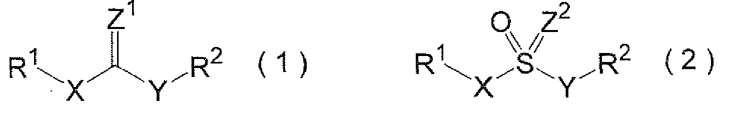 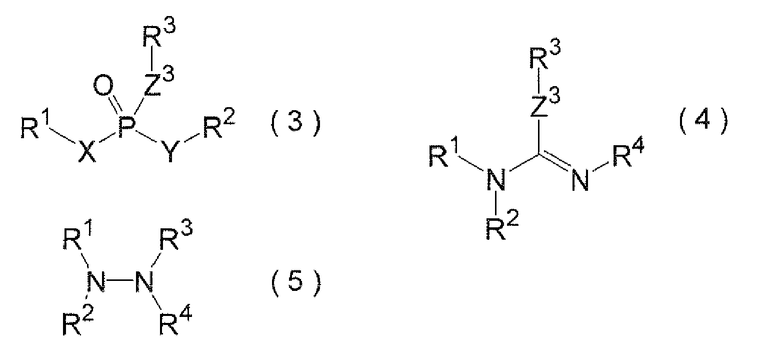 (In Formulae (1) to (5), X and Y independently denote a single bond, an oxygen atom, a sulfur atom, -C(R⁵)(R⁶)-, or -N(R⁵)-, Z¹ denotes an oxygen atom or a sulfur atom, Z² denotes an oxygen atom or a lone electron pair, Z³ denotes a single bond, an oxygen atom, a sulfur atom, -C(R⁵)(R⁶)-, or -N(R⁵)-, and R¹ to R⁶ independently denote a monovalent substituent comprising at least one type of atom selected from the group consisting of a hydrogen atom, a carbon atom, an oxygen atom, a nitrogen atom, a sulfur atom, a phosphorus atom, a halogen atom, and a silicon atom, any two or more of R¹ to R⁶ may be bonded to each other to form a ring, or R¹ to R⁶ may form a double bond together with X, Y, or Z³.)

The lithographic printing plate precursor of the present invention is explained in detail below.

### Photosensitive layer

In the present invention, the photosensitive layer comprises at least a polymerizable compound, a photopolymerization initiator, a binder polymer, and at least one compound, represented by any of Formulae (1) to (5), having at least one hydrophilic group and a molecular weight of no greater than 1,500. Furthermore, as necessary, it may comprise an optional component such as a sensitizing dye, a surfactant, a polymerization inhibitor, or a co-sensitizer. Each of the components forming the photosensitive layer of the lithographic printing plate precursor of the present invention is explained below.

### (A) Polymerizable Compound

In the present invention, a polymerizable compound for use in the photosensitive layer is preferably an addition-polymerizable compound having at least one ethylenically unsaturated bond, and is more preferably a compound having at least one, and preferably two or more, terminal ethylenically unsaturated bond. Such compounds are widely known in the art and they can be used in the present invention without any particular limitation. The compound has the chemical form of, for example, a monomer or a prepolymer and, specifically, a dimer, a trimer or an oligomer, or a copolymer thereof, or a mixture thereof.

Examples of the monomer include an unsaturated carboxylic acid (for example, acrylic acid, methacrylic acid, itaconic acid, crotonic acid, isocrotonic acid, or maleic acid) and an ester or amide thereof, and an ester of an unsaturated carboxylic acid with a polyhydric alcohol compound or an amide of an unsaturated carboxylic acid with a polyvalent amine compound is preferably used. An addition reaction product of an unsaturated carboxylic acid ester or amide having a nucleophilic substituent such as a hydroxy group, an amino group, or a mercapto group with a monofunctional or polyfunctional isocyanate or epoxy compound, or a dehydration condensation reaction product of an unsaturated carboxylic acid ester or amide having a nucleophilic substituent with a monofunctional or polyfunctional carboxylic acid is also suitably used. Moreover, an addition reaction product of an unsaturated carboxylic acid ester or amide having an electrophilic substituent such as an isocyanate group or an epoxy group with a monofunctional or polyfunctional alcohol, amine, or thiol, or a substitution reaction product of an unsaturated carboxylic acid ester or amide having a leaving group such as a halogen group or a tosyloxy group with a monofunctional or polyfunctional alcohol, amine, or thiol is also suitably used. In addition, compounds in which the unsaturated carboxylic acid described above is replaced by an unsaturated phosphonic acid, styrene, vinyl ether, etc. can also be used.

Specific examples of monomers that are esters of a polyhydric alcohol compound with an unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyioxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, ethylene oxide (EO)-modified isocyanurate triacrylate, and polyester acrylate oligomer.

As methacrylic acid esters there can be cited tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[*p*-(3-methacryloxy-2-hydroxypropoxy)phenyl]dimethylmethane, and bis[p-(methacryloxyethoxy)phenyl]dimethylmethane.

As itaconic acid esters there can be cited ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

As crotonic acid esters there can be cited ethylene glycol dicrotonate, tetramethylene glycol dicrotonate, pentaerythritol dicrotonate, and sorbitol tetracrotonate.

As isocrotonic acid esters there can be cited ethylene glycol diisocrotonate, pentaerythritol diisocrotonate, and sorbitol tetraisocrotonate.

As maleic acid esters there can cited ethylene glycol dimaleate, triethylene glycol dimaleate, pentaerythritol dimaleate, and sorbitol tetramaleate.

Other examples of esters that can be suitably used include aliphatic alcohol esters described in JP-B-51-47334 and JP-A-57-196231, esters having an aromatic skeleton described in JP-A-59-5240, JP-A-59-5241, and JP-A-2-226149, and esters containing an amino group described in JP-A-1-165613.

The above-mentioned ester monomers can also be used as a mixture.

Specific examples of monomers that are amides of a polyvalent amine compound with an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide, and xylylenebismethacrylamide. Other preferred examples of the amide monomer include amides having a cyclohexylene structure described in JP-B-54-21726.

Urethane-based addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A") below to a polyisocyanate compound having two or more isocyanate groups per molecule, described in JP-B-48-41708.

CH₂=C(R')COO(CH₂CH(R")O)ₙ₋₁CH₂CHR"OH (A")

### (R' and R" denote H or CH₃, and n denotes an integer of 1 to 30.)

Moreover, urethane acrylates described in JP-A-51-37193, JP-B-2-32293, and JP-B-2-16765, and urethane compounds having an ethylene oxide skeleton described in JP-B-58-49860, JP-B-56-17654, JP-B-62-39417 and JP-B-62-39418 are suitably used. Furthermore, a photopolymerizable composition having remarkably high photosensitive speed can be obtained by using an addition polymerizable compound having an amino structure or a sulfide structure in its molecule, described in JP-A-63-277653, JP-A-63-260909, and JP-A-1-105238.

Other examples include polyfunctional acrylates and methacrylates, for example, polyester acrylates and epoxy acrylates obtained by reacting an epoxy resin with (meth)acrylic acid ('(meth)acrylic' means both or either of 'acrylic' and 'methacrylic'.), described in JP-A-48-64183, JP-B-49-43191, and JP-B-52-30490. Specific unsaturated compounds described in JP-B-40-43946, JP-B-1-40337, and JP-B-1-40336, and vinylphosphonic acid-based compounds described in JP-A-2-25493 can also be cited. In some cases, a structure containing a perfluoroalkyl group described in JP-A-61-22048 can be suitably used. Moreover, photocurable monomers or oligomers described in Nippon Secchaku Kyokaishi (Journal of Japan Adhesion Society), Vol. 20, No. 7, pp. 300-308 (1984) can also be used.

Details of a method for using the polymerizable compound, for example, selection of the structure, single or combined use, or amount added, can be appropriately determined in accordance with the characteristic design of the final lithographic printing plate precursor. For example, the compound is selected from the following standpoints.

From the viewpoint of sensitivity, a structure having a large ethylenically unsaturated group content per molecule is preferable, and in many cases, a di-or higher-functional compound is preferable. Also, in order to increase the strength of the image area, that is, the cured film, a tri- or higher-functional compound is preferable. The combined use of compounds different in the number of functional groups or in the type of polymerizable group (for example, an acrylic acid ester, a methacrylic acid ester, a styrene compound, or a vinyl ether compound) is an effective method for controlling both sensitivity and strength.

The selection and method of use of the polymerizable compound are also important factors for compatibility and dispersibility with other components (for example, a binder polymer, a polymerization initiator, or a colorant) in the photosensitive layer. For example, compatibility may be improved in some cases by using a compound of low purity or by using two or more types of compounds in combination. A specific structure may be selected for the purpose of improving adhesion to a support, a protective layer, which is described below, etc. In the method of using the polymerizable compound, appropriate structure, combination, and amount added can be freely selected by taking account of the degree of polymerization inhibition due to oxygen, resolution, fogging properties, change in refractive index, surface tackiness, etc. Furthermore, depending on the case, the layer construction, for example, an undercoat layer or an overcoat layer, and the coating method may also be considered.

The amount of polymerizable compound used in the photosensitive layer is preferably 5 to 75 wt % relative to the total solids content of the photosensitive layer, more preferably 20 to 70 wt %, and yet more preferably 25 to 60 wt %. It is preferable for it to be in the above-mentioned range since high sensitivity and long plate life are achieved.

### (B) Photopolymerization initiator

The photosensitive layer contains a photopolymerization initiator.

A photopolymerization initiator is a compound that undergoes chemical change by actions such as electron transfer, energy transfer, or generation of heat caused by the electronically excited state of a sensitizing dye to thus generate at least one type selected from a radical, an acid, or a base. Hereinafter, a radical, an acid, and a base thus generated are simply called 'active species'. When there is no photopolymerization initiator or only a a photopolymerization initiator is used on its own, in practice sufficient sensitivity cannot be obtained. As one mode in which a sensitizing dye and a photopolymerization initiator are used in combination, they may be made into a single compound by an appropriate chemical method (linking the sensitizing dye and the photopolymerization initiator by a chemical bond, etc.) and used.

It is surmised that many of these photopolymerization initiators usually form an active species via initial chemical processes represented by (1) to (3) below. That is preferably (1) reductive decomposition of a photopolymerization initiator based on an electron transfer reaction from a sensitizing dye in an electronically excited state to the initiator compound, (2) oxidative decomposition of a photopolymerization initiator based on electron transfer from the photopolymerization initiator a sensitizing dye in an electronically excited state, and (3) decomposition of a photopolymerization initiator in an electronically excited state based on energy transfer from a sensitizing dye in an electronically excited state to the photopolymerization initiator. Although there is often some ambiguity with respect to which individual initiator compound belongs to which type of (1) to (3), the sensitizing dye in the present invention exhibits a very high sensitizing effect in combination with any type of these initiator compounds.

As the photopolymerization initiator, a compound known to a person skilled in the art may be used without any restrictions, and specific examples thereof include a trihalomethyl compound, a carbonyl compound, an organic peroxide, an azo type compound, an azide compound, a metallocene compound, a hexaarylbiimidazole compound, an organic boron compound, a disulfone compound, an oxime ester compound, an onium salt compound, and an iron arene complex. Among them, it is preferably at least one type selected from the group consisting of a hexaarylbiimidazole-based compound, an onium salt, a trihalomethyl compound, and a metallocene compound, and it is particularly preferably a hexaarylbiimidazole-based compound.

Furthermore, the photopolymerization initiator may be used in a combination of two or more types.

As the hexaarylbiimidazole compound, there can be cited lophine dimers described in JP-B-45-37377 and JP-B-44-86516 (JP-B denotes a Japanese examined patent application publication), and examples thereof include 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(*o*,*p*-dichlorophenyl)-4,4',5,5'-tetraphenylbiimidazole, 2,2'-bis(*o*-chlorophenyl)-4,4',5,5'-tetra(*m-*methoxyphenyl)biimidazole, 2,2'-bis(*o*,*o*'-dichlorophenyl)-4,4',5,5'-tetraphenylbiimidazole, 2,2'-bis(*o*-nitrophenyl)-4,4',5,5'-tetraphenylbiimidazole, 2,2'-bis(*o*-methylphenyl)-4,4',5,5'-tetraphenylbiimidazole, and 2,2'-bis(*o-*trifluorophenyl)-4,4',5,5'-tetraphenylbiimidazole.

The hexaarylbiimidazole-based compound is particularly preferably used in a combination with a sensitizing dye having a maximum absorption at 300 to 450 nm.

The onium salt (functioning as an ionic polymerization initiator in the present invention, not as an acid generator) that is suitably used in the present invention is an onium salt represented by Formulae (RI-I) to (RI-III) below.

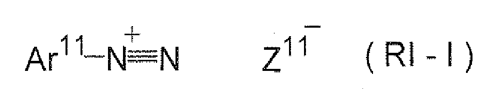

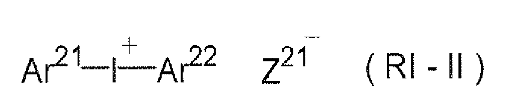

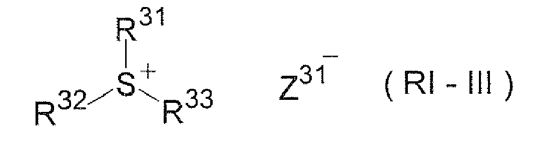

In formula (RI-I), Ar₁₁ denotes an aryl group that has no greater than 20 carbon atoms and that may have 1 to 6 substituents. Preferable examples of the substituent include an alkyl group having 1 to 12 carbon atoms, an alkenyl group having 2 to 12 carbon atoms, an alkynyl group having 2 to 12 carbon atoms, an aryl group having 6 to 12 carbon atoms, an alkoxy group having 1 to 12 carbon atoms, an aryloxy group having 6 to 12 carbon atoms, a halogen atom, an alkylamino group having 1 to 12 carbon atoms, a dialkylamino group having 2 to 24 carbon atoms, an alkylamide group having 1 to 12 carbon atoms, an arylamide group having 6 to 12 carbon atoms, a carbonyl group, a carboxy group, a cyano group, a sulfonyl group, a thioalkyl group having 1 to 12 carbon atoms, and a thioaryl group having 6 to 12 carbon atoms.

In Formula (RI-I), Z₁₁⁻ denotes a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion or a carboxylate ion. Among them, a perchlorate ion, a hexafluorophosphate ion, a tetrafluoroborate ion, a sulfonate ion, and a sulfinate ion are preferable from the viewpoint of stability.

In formula (RI-II), Ar₂₁ and Ar₂₂ independently denote an aryl group that has no greater than 20 carbon atoms and that may have 1 to 6 substituents. Preferable examples of the substituent include an alkyl group having 1 to 12 carbon atoms, an alkenyl group having 2 to 12 carbon atoms, an alkynyl group having 2 to 12 carbon atoms, an aryl group having 6 to 12 carbon atoms, an alkoxy group having 1 to 12 carbon atoms, an aryloxy group having 6 to 12 carbon atoms, a halogen atom, an alkylamino group having 1 to 12 carbon atoms, a dialkylamino group having 2 to 24 carbon atoms, an alkylamide group having 1 to 12 carbon atoms, an arylamide group having 6 to 12 carbon atoms, a carbonyl group, a carboxy group, a cyano group, a sulfonyl group, a thioalkyl group having 1 to 12 carbon atoms, or a thioaryl group having 6 to 12 carbon atoms.

In Formula (RI-II), Z₂₁⁻ denotes a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a sulfonate ion, a sulfinate ion, and a carboxylate ion are preferable from the viewpoint of stability and reactivity.

In Formula (RI-III), R₃₁, R₃₂, and R₃₃ independently denote an aryl group that has no greater than 20 carbon atoms and that may have 1 to 6 substituents, an alkyl group, an alkenyl group, or an alkynyl group. Among them, the aryl group is preferable from the viewpoint of reactivity and stability.

Examples of the substituent include an alkyl group having no greater than 12 carbon atoms, an alkenyl group having no greater than 12 carbon atoms, an alkynyl group having no greater than 12 carbon atoms, an aryl group having no greater than 12 carbon atoms, an alkoxy group having no greater than 12 carbon atoms, an aryloxy group having no greater than 12 carbon atoms, a halogen atom, an alkylamino group having no greater than 12 carbon atoms, a dialkylamino group having no greater than 12 carbon atoms, an alkylamide group having no greater than 12 carbon atoms, an arylamide group having no greater than 12 carbon atoms, a carbonyl group, a carboxy group, a cyano group, a sulfonyl group, a thioalkyl group having no greater than 12 carbon atoms, and a thioaryl group having no greater than 12 carbon atoms.

In Formula (RI-III), Z³¹⁻ denotes a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion, and a carboxylate ion. Among them, a perchlorate ion, a hexafluorophosphate ion, a tetrafluoroborate ion, a sulfonate ion, a sulfinate ion, and a carboxylate ion are preferable from the viewpoint of stability and reactivity. Carboxylate ions described in JP-A-2002-148790 and JP-A-2001-343742 are more preferable, and carboxylate ions described in JP-A-2002-148790 are yet more preferable.

The onium salt is particularly preferably used in combination with an IR absorber having a maximum absorption at 750 to 1,400 nm.

As other polymerization initiators, polymerization initiators described in JP-A-2007-171406, JP-A-2007-206216, JP-A-2007-206217, JP-A-2007-225701, JP-A-2007-225702, JP-A-2007-316582, and JP-A-2007-328243 may preferably be used.

With regard to the polymerization initiator in the present invention, one type thereof may suitably used on its own or two or more types thereof may be used in combination.

The amount of polymerization initiator used in the photosensitive layer in the present invention is preferably 0.01 to 20 wt % relative to the total weight of the solids content of the photosensitive layer, more preferably 0.1 to 15 wt %, and yet more preferably 1.0 to 10 wt %. It is preferable for it to be in the above-mentioned range since high sensitivity, long plate life, and high stability are achieved.

### (C) Binder polymer

The photosensitive layer of the lithographic printing plate precursor further employs a binder polymer. The binder polymer is a polymer that functions as a film-forming agent of the photosensitive layer, and preferably comprises a linear organic polymer. As such a 'linear organic polymer', a known polymer may be used.

Preferred examples of such a binder polymer include polymers selected from the group consisting of an acrylic resin, a polyvinylacetal resin, a polyurethane resin, a polyamide resin, an epoxy resin, a methacrylic resin, a styrene-based resin, and a polyester resin. Among them, an acrylic resin and a polyurethane resin are preferable. The 'acrylic resin' referred to here means an acrylic polymer having an acrylic acid derivative as a (co)polymer component. The 'polyurethane resin' referred to here means a polymer formed by a condensation reaction of a compound having two isocyanate groups and a compound having two or more hydroxy groups.

Crosslinking properties may be imparted to the binder polymer in order to increase the film strength of the image area. In order to impart crosslinking properties to the binder polymer, a crosslinkable functional group such as an ethylenically unsaturated bond, is introduced into a main chain or side chain of the polymer. The crosslinkable functional group may be introduced by copolymerization or a polymer reaction.

The term 'crosslinkable group' as used herein means a group capable of crosslinking the binder polymer in the process of a radical polymerization reaction caused in the photosensitive layer when the lithographic printing plate precursor is exposed. The crosslinkable group is not particularly restricted as long as it has such a function and includes, for example, an ethylenically unsaturated bond group, an amino group, or an epoxy group as a functional group capable of undergoing an addition polymerization reaction. Also, a functional group capable of forming a radical upon irradiation with light may be used and such a crosslinkable group includes, for example, a thiol group, a halogen atom, and an onium salt structure. Among them, the ethylenically unsaturated bond group is preferable, and functional groups represented by formulae (1') to (3') below are particularly preferable.

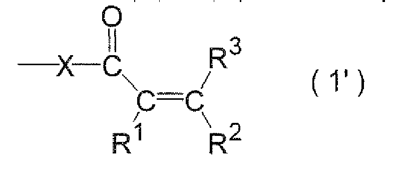

In formula (1') above, R¹ to R³ independently denote a hydrogen atom or a monovalent substituent.

R¹ preferably includes, for example, a hydrogen atom or an optionally substituted alkyl group. Among them, a hydrogen atom or a methyl group is preferable because of high radical reactivity.

R² and R³ independently denote a hydrogen atom, a halogen atom, an amino group, a carboxy group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, an optionally substituted arylsulfonyl group, etc. Among them, a hydrogen atom, a carboxy group, an alkoxycarbonyl group, an optionally substituted alkyl group, or an optionally substituted aryl group is preferable because of high radical reactivity.

X denotes an oxygen atom, a sulfur atom, or -N(R¹²)-, and R¹² denotes a hydrogen atom or a monovalent organic group. The monovalent organic group denoted by R¹² includes, for example, an optionally substituted alkyl group. Among them, a hydrogen atom, a methyl group, an ethyl group, or an isopropyl group is preferable because of high radical reactivity.

Examples of the substituent that can be introduced include an alkyl group, an alkenyl group, an alkynyl group, an aryl group, an alkoxy group, an aryloxy group, a halogen atom, an amino group, an alkylamino group, an arylamino group, a carboxy group, an alkoxycarbonyl group, a sulfo group, a nitro group, a cyano group, an amide group, an alkylsulfonyl group, and an arylsulfonyl group.

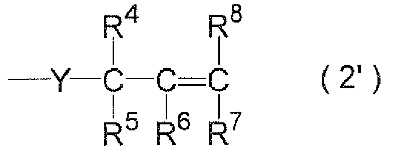

In formula (2') above, R⁴ to R⁸ independently denote a hydrogen atom or a monovalent substituent.

R⁴ to R³ are preferably, for example, a hydrogen atom, a halogen atom, an amino group, a dialkylamino group, a carboxy group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group. Among them, a hydrogen atom, a carboxy group, an alkoxycarbonyl group, an optionally substituted alkyl group, or an optionally substituted aryl group is preferable.

Examples of the substituent that can be introduced include those described for Formula (1').

Y denotes an oxygen atom, a sulfur atom, or N(R¹²). R¹² has the same meaning as R¹² defined in Formula (1), and preferred examples thereof are also the same.

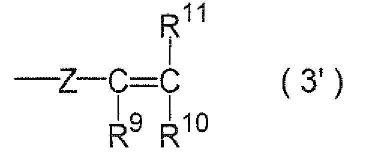

In formula (3') above, R⁹ to R¹¹ independently denote a hydrogen atom or a monovalent substituent.

R⁹ preferably denotes a hydrogen atom or an optionally substituted alkyl group. Among them, a hydrogen atom or a methyl group is preferable because of high radical reactivity.

R¹⁰ and R¹¹ independently denote, for example, a hydrogen atom, a halogen atom, an amino group, a dialkylamino group, a carboxy group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group. Among them, a hydrogen atom, a carboxy group, an alkoxycarbonyl group, an optionally substituted alkyl group, or an optionally substituted aryl group is preferable because of high radical reactivity.

Examples of the substituent that can be introduced include those described in Formula (1').

Z denotes an oxygen atom, a sulfur atom, N(R¹³), or an optionally substituted phenylene group.

R¹³ denotes an optionally substituted alkyl group, etc. Among them, a methyl group, an ethyl group, or an isopropyl group is preferable because of high radical reactivity.

Among the polymers, a (meth)acrylic acid copolymer and a polyurethane, each having a crosslinkable group in a side chain thereof, are more preferable.

In the binder polymer having crosslinking properties, for example, a free radical (a polymerization initiating radical or a propagating radical in the process of polymerization of the polymerizable compound) is added to the crosslinkable functional group to cause addition-polymerization between polymers directly or through a polymerization chain of the polymerizable compound; as a result, crosslinking is formed between polymer molecules to effect curing. Alternatively, an atom (for example, a hydrogen atom on a carbon atom adjacent to the functional crosslinkable group) in the polymer is abstracted by a free radical to produce a polymer radical, and polymer radicals combine with each other to form crosslinking between polymer molecules to effect curing.

The content of the crosslinkable group (content of radically polymerizable unsaturated double bond determined by iodine titration) in the binder polymer is preferably 0.1 to 10.0 mmol, more preferably 1.0 to 7.0 mmol, and most preferably 2.0 to 5.5 mmol, per g of the binder polymer.

Furthermore, the binder polymer used is appropriately selected according to the mode of development processing so that a non-image area of the photosensitive layer is removed well in a plate making process for the lithographic printing plate precursor. Details are described below.

### (C-1) Alkali-soluble binder polymer

In a mode in which development processing is carried out using an alkali developer having a pH of greater than 7 but no greater than 11, since it is necessary to dissolve a binder polymer in an alkali developer having a pH of greater than 7 but no greater than 11, an organic polymer that is soluble in an aqueous alkali having a pH of greater than 8 but no greater than 10 is preferably used.

It is preferable for the binder polymer to have an alkali-soluble group such that it can be dissolved in an aqueous alkali having a pH of greater than 7 but no greater than 11. The alkali-soluble group is preferably an acid group, and examples thereof include a carboxy group, a sulfonic acid group, a phosphoric acid group, and a hydroxy group. Among them, from the viewpoint of achieving a balance between film properties, plate life, and developability, a binder polymer having a carboxy group or a carboxylic acid ester group with a lower alkyl alcohol having 1 to 3 carbon atoms is particularly preferable.

As the carboxy group-containing binder polymer that is suitably used in the present invention, a resin having (meth)acrylic acid as a copolymerization component is preferable. From the viewpoint of developability, the (meth)acrylic acid is preferably 5 to 70 wt % of the polymerization components, particularly preferably 10 to 50 wt %, and most preferably 10 to 40 wt %.

In particular, the carboxy group-containing binder polymer is preferably a copolymer between (meth)acrylic acid and an alkyl (meth)acrylate. The alkyl of the alkyl (meth)acrylate is preferably a straight chain, branched, or cyclic alkyl having no greater than 10 carbon atoms. The copolymerization ratio by weight of (meth)acrylic acid to the alkyl (meth)acrylate is preferably 30:70 to 95:5, particularly preferably 50:50 to 90:10, and most preferably 60:40 to 90:10.

Moreover, the alkali-soluble binder polymer may be given crosslinking properties as described above in order to improve film strength of an image area. In order to impart crosslinking properties to the binder polymer, a crosslinkable functional group such as an ethylenically unsaturated bond may be introduced into a main chain or a side chain of the polymer. The crosslinkable functional group may be introduced by copolymerization or a polymer reaction.

The alkali-soluble binder polymer preferably has a weight-average molecular weight of 5,000 or more, and more preferably 10,000 to 300,000, and a number-average molecular weight of 1,000 or more, and more preferably 2,000 to 250,000. The polydispersity (weight-average molecular weight/number-average molecular weight) is preferably 1.1 to 10.

The alkali-soluble binder polymer may be any of a random polymer, a block polymer, a graft polymer, etc., and is preferably a random polymer.

The alkali-soluble binder polymer may be used singly or in a combination of two or more types as a mixture.

The content of the alkali-soluble binder polymer is preferably 5 to 90 wt % relative to the total solids content of the photosensitive layer, more preferably 10 to 50 wt %, and yet more preferably 10 to 40 wt %. When in the above-mentioned range, good strength for an image area and good image formation properties are obtained.

### (C-2) Hydrophilic group-containing binder polymer

As a binder polymer that can be used in the photosensitive layer, in order to improve developability by the developer, a binder polymer having a hydrophilic group (hydrophilic group-containing binder polymer) may be used. In particular, when an acidic to weakly alkaline developer is used, a hydrophilic group-containing binder polymer is preferably used.

The hydrophilic group is selected from monovalent and di- or higher-valent hydrophilic groups, and preferred examples thereof include a hydroxy group, a sulfonic acid group, a carboxylic acid group, a phosphoric acid group, an alkyleneoxy group such as an ethyleneoxy group or a propyleneoxy group, a primary amino group, a secondary amino group, a tertiary amino group, a salt formed by neutralizing an amino group with an acid, a quaternary ammonium group, a sulfonium group, an iodonium group, a phosphonium group, an amide group, an ether group, and a salt formed by neutralizing an acid group such as a carboxylic acid, sulfonic acid, or phosphoric acid; particularly preferred examples thereof include a primary amino group, a secondary amino group, a tertiary amino group, a salt formed by neutralizing an amino group with an acid, a quaternary ammonium group, an amide group, a hydroxy group, a -CH₂CH₂O-repeating unit, and a -CH₂CH₂NH- repeating unit, and most preferred examples thereof include a tertiary amino group, a salt formed by neutralizing an acid group with an amino group-containing compound, a salt formed by neutralizing an amino group with an acid, and a quaternary ammonium group.

The hydrophilic group-containing binder polymer is preferably a copolymer, and from the viewpoint of developability the proportion of the copolymer component having a hydrophilic group described above in the total copolymer components of the copolymer is preferably 1 to 70% relative to the total monomer units forming the copolymer, and from the viewpoint of a balance being achieved between developability and plate life it is preferably 1 to 50% and particularly preferably 1 to 30%.

With regard to the skeleton of such a hydrophilic group-containing binder polymer, a polymer selected from the group consisting of an acrylic resin, a polyvinylacetal resin, a polyvinyl alcohol resin, a polyurethane resin, a polyamide resin, an epoxy resin, a methacrylic resin, a styrene-based resin, and a polyester resin is preferable. Among them, a vinyl (co)polymer such as an acrylic resin, a methacrylic resin, or a styrene-based resin or polyurethane resin is particularly preferable.

The hydrophilic group-containing binder polymer preferably has the type of crosslinkable group described above.

The content of the crosslinkable group (content of radically polymerizable unsaturated double bond determined by iodine titration) in the hydrophilic group-containing binder polymer is preferably 0.01 to 10.0 mmol, more preferably 0.05 to 5.0 mmol, and yet more preferably 0.1 to 2.0 mmol, per g of the hydrophilic group-containing binder polymer.

From the viewpoint of further improvement of plate life, the crosslinkable group is desirably in the vicinity of the hydrophilic group, and the hydrophilic group and the crosslinkable group may be present on the same polymerization unit.

The hydrophilic group-containing binder polymer preferably has, in addition to the above-mentioned hydrophilic group-containing unit, crosslinkable group-containing unit, and hydrophilic group- and crosslinkable group-containing unit, an alkyl or aralkyl (meth)acrylate unit. The alkyl group of the alkyl (meth)acrylate is preferably an alkyl group having 1 to 5 carbon atoms, and more preferably a methyl group. Examples of the aralkyl (meth)acrylate include benzyl (meth)acrylate.

The hydrophilic group-containing binder polymer preferably has a weight-average molecular weight of 5,000 or more, and more preferably of 10,000 to 300,000, and a number-average molecular weight of 1,000 or more, and more preferably 2,000 to 250,000. The polydispersity (weight-average molecular weight/number-average molecular weight) is preferably 1.1 to 10.

The hydrophilic group-containing binder polymer may be any of a random polymer, a block polymer, a graft polymer, etc.

The hydrophilic group-containing binder polymer may be used singly or in a combination of two or more thereof.

From the viewpoint of strength of the image area and good image-forming properties, the content of the hydrophilic group-containing binder polymer is preferably 5 to 75 wt %, more preferably 10 to 70 wt %, and yet more preferably 10 to 60 wt %, relative to the total solids content of the photosensitive layer.

Furthermore, the total content of the polymerizable compound and the binder polymer is preferably no greater than 80 wt % relative to the total solids content of the photosensitive layer, and more preferably 35 to 75 wt %. When in the above-mentioned range, sensitivity and developability are excellent.

Specific examples of polymerization units constituting the hydrophilic group-containing binder polymer and specific examples of the hydrophilic group-containing binder polymer are shown below, but the present invention is not limited by these examples. Weight-average molecular weight (Mw, also expressed simply as 'molecular weight' in the table below) in the table below is measured by gel permeation chromatography (GPC) using polystyrene as a reference material. In the chemical formulae below, TsO⁻ is an abbreviation for *p*-CH₃C₆H₄SO₃⁻.

| No. | Binder Structure (mol %) | Molecular Weight |
|---|---|---|
| P-1 | 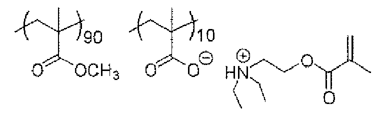 | 80.000 |
| P-2 | 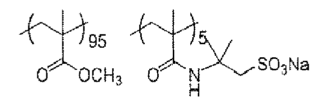 | 72,000 |

| No. | Diisocyanate compound used (mol %) | Diol compound used (mol %) | Molecular Weight |
|---|---|---|---|
| P-3 | 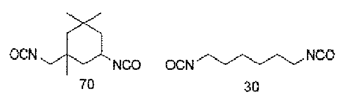 | 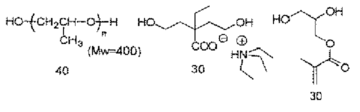 | 60,000 |

| No. | Binder Structure (mol %) | Molecular Weight |
|---|---|---|
| P-4 | 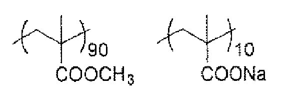 | 50,000 |
| P-5 | 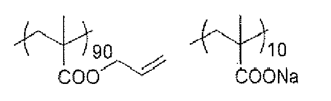 | 60,000 |
| P-6 | 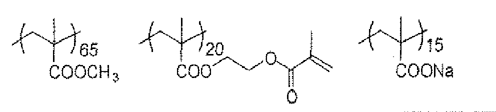 | 65,000 |
| P-7 | 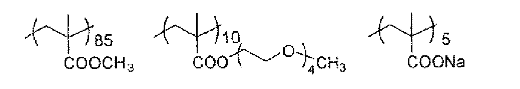 | 60,000 |
| P-8 | 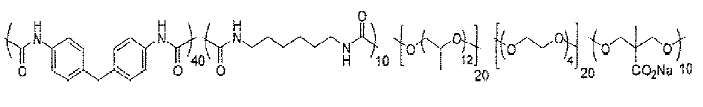 | 63,000 |
| P-9 | 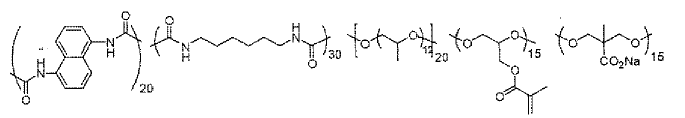 | 60,000 |

| No. | Binder Structure (mol %) | Molecular Weight |
|---|---|---|
| P-10 | 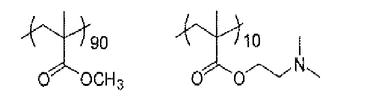 | 70,000 |
| P-11 | 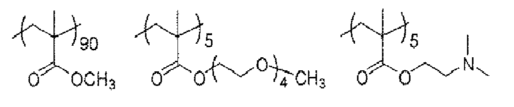 | 80,000 |
| P-12 | 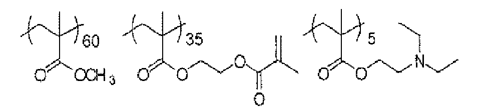 | 80,000 |

| No. | Diisocyanate Compound used (mol %) | Diol compound used (mol %) | Molecular Weight |
|---|---|---|---|
| P-13 | 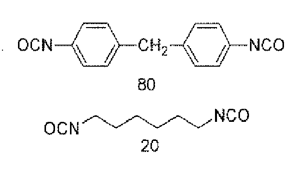 | 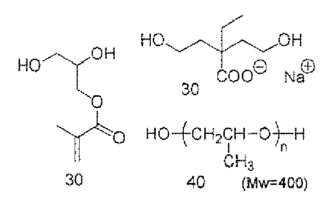 | 57,000 |

| No. | Binder Structure (mol %) | Molecular Weight |
|---|---|---|
| P-14 | 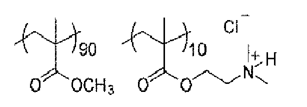 | 70,000 |
| P-15 | 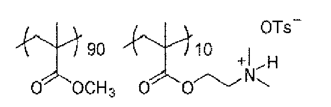 | 58,000 |
| P-16 | 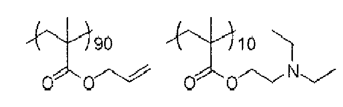 | 90,000 |
| P-17 | 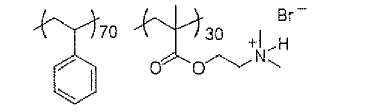 | 62,000 |
| P-18 | 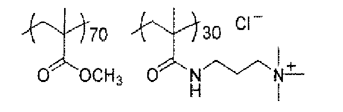 | 58,000 |
| P-19 | 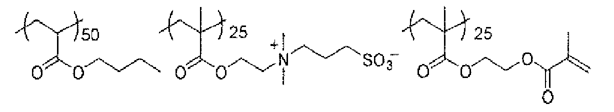 | 49,000 |

| No. | Diisocyanate compound used (mol %) | Diol compound used (mol %) | Molecular Weight |
|---|---|---|---|
| P-20 | 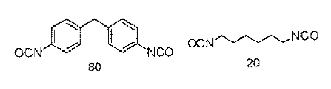 | 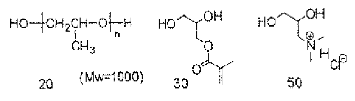 | 59,000 |
| P-21 | 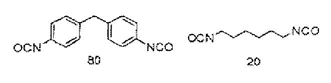 | 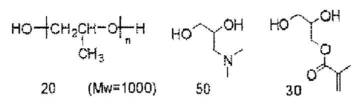 | 59,000 |
| P-22 | 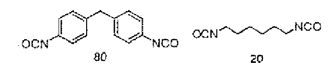 | 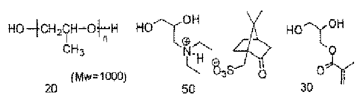 | 62,000 |
| P-23 | 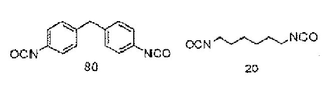 | 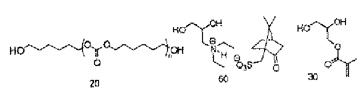 | 53.000 |

| No. | Binder Structure (mol %) | Molecular Weight |
|---|---|---|
| P-24 | 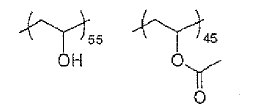 | 80,000 |
| P-25 | 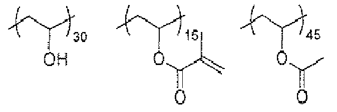 | 100,000 |

| No. | Binder Structure (mol %) | Molecular Weight |
|---|---|---|
| P-26 | 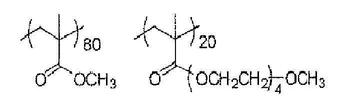 | 80,000 |
| P-27 | 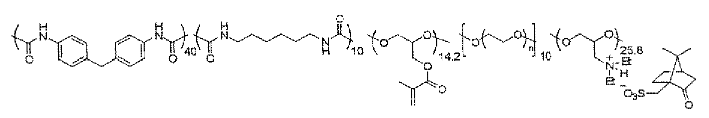 | 70,000 |
| P-28 | 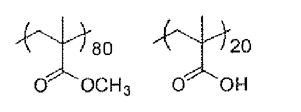 | 50,000 |
| P-29 | 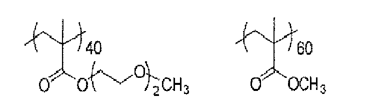 | 80,000 |

### (D) Compound represented by Formulae (1) to (5)

In the present invention, the photosensitive layer comprises at least one compound, represented by any of Formulae (1) to (5), having at least one hydrophilic group and a molecular weight of no greater than 1,500. 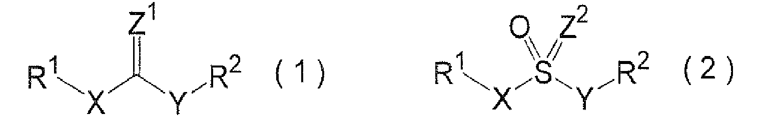 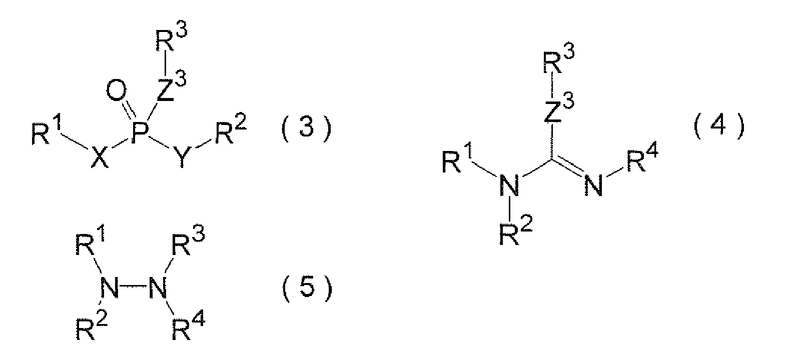 (In Formulae (1) to (5), X and Y independently denote a single bond, an oxygen atom, a sulfur atom, a -C(R⁵)(R⁶)-, or -N(R⁵)-, Z¹ denotes an oxygen atom or a sulfur atom, Z² denotes an oxygen atom or a lone electron pair, Z³ denotes a single bond, an oxygen atom, a sulfur atom, -C(R⁵)(R⁶)-, or -N(R⁵)-, and R¹ to R⁶ independently denote a monovalent substituent comprising at least one type of atom selected from the group consisting of a hydrogen atom, a carbon atom, an oxygen atom, a nitrogen atom, a sulfur atom, a phosphorus atom, a halogen atom, and a silicon atom, any two or more of R¹ to R⁶ may be bonded to each other to form a ring, or R¹ to R⁶ may form a double bond together with X, Y, or Z³.)

In accordance with the investigation by the present inventors it has been found that, when a compound represented by Formulae (1) to (5) is added to a photosensitive layer, compared with a photosensitive layer to which it is not added, the rate of reaction of the polymerizable compound when exposed to a laser improves, and the speed of development by a non-strongly alkaline developer (pH 2 to 11) increases. This enables the developability to be improved while maintaining at least the same level of plate life compared with a lithographic printing plate precursor to which a compound represented by Formulae (1) to (5) is not added, thereby improving productivity and staining properties.

The compound represented by Formulae (1) to (5) has at least one hydrophilic group in the molecule. Preferred examples of the hydrophilic group include an acid group, an amide group, an alkylene oxide group, an ammonium group, a hydroxy group, and sulfonamide group.

The position of the hydrophilic group is not limited as long as it is bonded in the compound represented by Formulae (1) to (5). Furthermore, the structure represented by Formulae (1) to (5) may form part of a hydrophilic group or, conversely, part of a hydrophilic group may form part of the structure represented by Formulae (1) to (5).

As the acid group, there can be cited a carboxylic acid group, a sulfonic acid group, a sulfinic acid group, a phosphoric acid group, and a phosphonic acid group, and an acid salt group in which a metal ion such as Na⁺ or K⁺ is bonded is also included.

As the amide group, a group formed by abstracting one hydrogen atom from a primary amide (RCONR'R"), a secondary amide ((RCO)₂NR'), or a tertiary amide ((RCO)₃N) can be cited, and among them a primary amide group is preferable. As R, R', and R" contained in the amide group, a hydrogen atom, a straight-chain or branched alkyl group having 1 to 10 carbon atoms, or an aromatic group having 6 to 12 carbon atoms can be cited; among them an alkyl group having 1 to 3 carbon atoms is preferable, and a methyl group is more preferable.

As the alkylene oxide group, an alkylene oxide group having 1 to 5 carbon atoms and a group having this linked as a repeating unit are preferable, and a group in which 2 to 5 ethylene oxide groups are linked and a group in which 2 to 5 propylene oxide groups are linked are more preferable.

As the ammonium group, a group formed by abstracting one hydrogen atom from a primary to quaternary ammonium, that is, NH₄⁺ and NH₄⁺ in which H is replaced by an alkyl group having 1 to 10 carbon atoms can be cited, and among them a group formed by abstracting one hydrogen atom from a quaternary ammonium (N(R)₄⁺) is preferable. The alkyl group is preferably a straight-chain alkyl group having 1 to 5 carbon atoms, and more preferably a methyl group or an ethyl group.

As the sulfonamide group, a group formed by abstracting one hydrogen atom from a sulfonic acid amide (RSO₂NR'R") can be cited, and R, R', and R" are a hydrogen atom or an alkyl group having 1 to 10 carbon atoms. Among them, a group formed by abstracting one hydrogen atom from RSO₂NH₂, in which the substituents (R' and R") on the nitrogen atom are hydrogen atoms, is preferable, and R is preferably an alkyl group having 1 to 3 carbon atoms, and more preferably a methyl group or an ethyl group.

The hydrophilic group may be a group in which two or more hydrophilic groups are combined, and preferred examples of the combination include a combination of an alkylene oxide group and a hydroxy group or an ammonium group.

The compound represented by Formulae (1) to (5) has a molecular weight of no greater than 1,500. When the molecular weight exceeds 1,500, the developability is poor. The molecular weight of the compound is preferably 100 to 1,000. It is preferable for it to be in the above-mentioned range since the developability is good.

In Formulae (1) to (5), X and Y independently denote a single bond, an oxygen atom, a sulfur atom, -C(R⁵)(R⁶)-, or -N(R⁵)-.

Z¹ denotes an oxygen atom or a sulfur atom, and preferably an oxygen atom.

Z² denotes an oxygen atom or a lone electron pair, and preferably an oxygen atom.

Z³ denotes a single bond, an oxygen atom, a sulfur atom, -C(R⁵)(R⁶)-, or
- N(R⁵)-. For a compound represented by Formula (3), Z³ is preferably a single bond or an oxygen atom, and for a compound represented by Formula (4), Z³ is preferably a single bond or a sulfur atom.

R¹ to R⁶ independently denote a monovalent substituent comprising at least one type of atom selected from the group consisting of a hydrogen atom, a carbon atom, an oxygen atom, a nitrogen atom, a sulfur atom, a phosphorus atom, a halogen atom, and a silicon atom, any two or more of R¹ to R⁶ may form together a single bond or a double bond to thus form a ring, or R¹ to R⁶ may form a double bond together with X, Y, or Z³ (in Formula (4) and Formula (5), a nitrogen atom).

As the ring, there can be cited an alicyclic hydrocarbon and aromatic hydrocarbon that may contain a heteroatom such as an oxygen atom, a sulfur atom, or a nitrogen atom.

Specific examples of R¹ to R⁶ include a hydrogen atom, the above-mentioned hydrophilic group, a cyclic, straight-chain, or branched alkyl group having no greater than 10 carbon atoms, an aryl group having 6 to 20 carbon atoms, a cyclic, straight-chain, or branched alkenyl group having no greater than 10 carbon atoms, a cyclic, straight-chain, or branched alkynyl group having no greater than 10 carbon atoms, a 3- to 10-membered heterocyclic group, a 5- to 20-membered heteroaromatic ring group, an amino group, and a group formed by combining the above.

The compound represented by Formulae (1) to (5) may have a substituent at any position, and as the substituent there can be cited an alkyl group having 1 to 3 carbon atoms, an alkoxy group having 1 to 3 carbon atoms, a halogen atom (a fluorine atom, a chlorine atom, a bromine atom, or an iodine atom), an oxo group, an amino group, etc.

The compound represented by Formula (1) is preferably one containing a cyclic structure, and particularly preferably a compound containing a structure represented by Formula (1-1) to Formula (1-4).

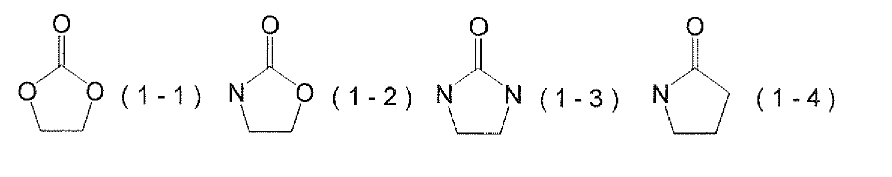

The compound represented by Formula (2) is preferably a compound containing a structure represented by Formula (2-1) to Formula (2-3).

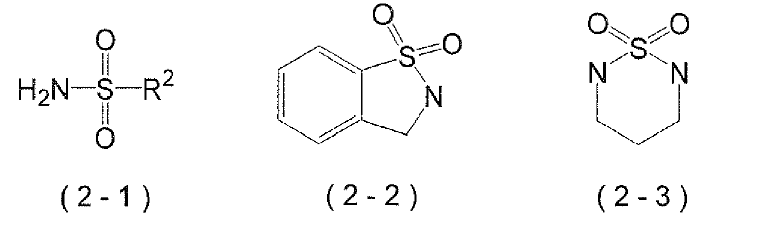

The compound represented by Formula (3) is preferably one containing a cyclic structure, and more preferably a compound containing a structure represented by Formula (3-1) or Formula (3-2).

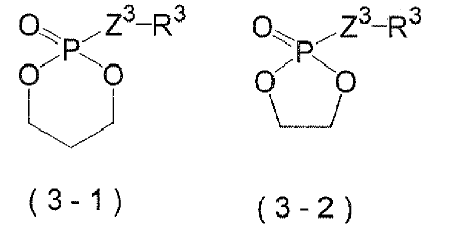

In Formula (3-1) and Formula (3-2), Z³ is preferably a single bond or an oxygen atom.

R³ is preferably a group in which an alkyl group having 1 to 5 carbon atoms and a hydrophilic group are combined, and more preferably a hydrophilic group that is bonded via an alkylene group having 1 to 3 carbon atoms.

The compound represented by Formula (4) is preferably one containing a cyclic structure, and more preferably a compound containing a structure represented by Formula (4-1) or Formula (4-2).

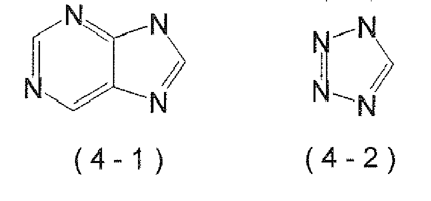

The structure represented by Formula (4-1) is preferably a structure having an oxo group further bonded thereto. The compound represented by Formula (4) is preferably a compound represented by Formula (4-1-1) or Formula (4-1-2).

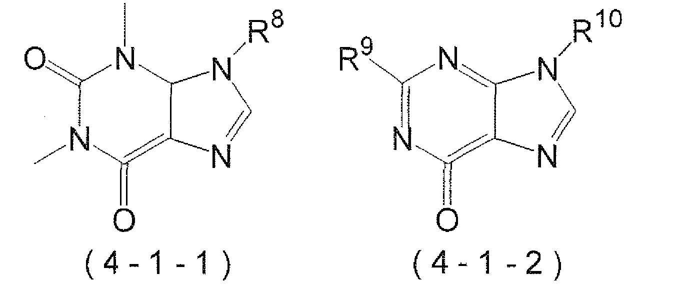

In Formula (4-1-1) and Formula (4-1-2), R⁸ to R¹⁰ independently denote an alkyl group having no greater than 10 carbon atoms, an arylene group having no greater than 20 carbon atoms, a hydrophilic group, or a combination thereof.

The compound represented by Formula (5) is preferably one containing a cyclic structure, and more preferably a compound containing a structure represented by Formula (5-1) or Formula (5-2). In Formula (5-1), R¹ and R³ are the same as R¹ and R³ in Formula (5). As shown in Formula (5-2), a double bond with a nitrogen atom may be formed, and in this case R¹ and R³ in Formula (5-1) are excluded.

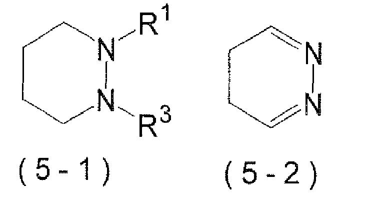

In the present invention, a compound represented by Formula (5) is preferably one containing a structure represented by Formula (5-2), and more preferably a compound containing a structure represented by Formula (5-3).

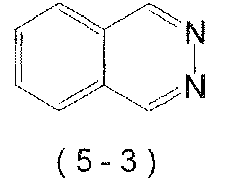

The compound represented by Formulae (1) to (5) used in the present invention preferably has a dipole moment of at least 3.8 Debye, more preferably a dipole moment of at least 4.0 Debye, and particularly preferably a dipole moment of at least 4.5 Debye. High plate life can be obtained when the dipole moment is at least 3.8 Debye.

The dipole moment in the present invention employs a value calculated by the method below using a molecular orbital method. The dipole moment is calculated by solving the Hartree-Fock-Roothaan equation FC = SCE (F; Hartree-Fock matrix, C; AO coefficient matrix, S; overlap integral, E; energy eigenvalue diagonal matrix), and in the present invention 'MOPAC', which is a calculation program for a semiempirical molecular orbital method, is used. 'MOPAC' is a method in which the amount of calculation is greatly reduced by neglecting differential overlap in two-electron integration and, furthermore, by using experimental values of atoms or typical molecules as parameters (e.g. AM1 parameters) instead of integral calculation, and is well known in the art; details thereof are described in 'Dai 5-han Jikken Kagaku Koza 12 Keisan Kagaku' (Experimental Chemistry Series 12 Calculation Chemistry 5th edition) (Maruzen) pp. 48-59 (edited by The Chemical Society of Japan). The dipole moment in the present specification may be calculated by reference to these descriptions.

The compound represented by Formulae (1) to (5) used in the present invention preferably has a Log P value of less than 1, more preferably less than 0.75, and particularly preferably less than 0.5. When the Log P value is less than 1, the developability improves.

The Log P value in the present invention employs a value calculated using the CLOGP Log P value estimation program (CLOGP program installed in a system: PC Models (ver 1.02) of Daylight Information Systems, Inc.; algorism = 4.01, fragment data base = 17) developed in the Medchem Project of C. Hansch, A. Leo et al. of Pomona College, USA. The program is based on the Hansch-Leo fragment method, and log P is calculated by dividing a chemical structure into a partial structure (fragment) and summing up a contribution extent of log P assigned to the fragment. The method is described in greater detail in C. Hansen and A. Leo, "Substituent Constants for Correlation Analysis in Chemistry and Biology", John Wiley & Sons, and A. J. Leo "Calculating log Poct from Structures", Chem. Rev., Vol. 93, pages 1281 to 1306 (1993), and the description herein can be referred to.

Specific examples of compounds which can be used in the present invention are shown below, but the present invention is not limited by these examples.

| No. | Compound | Dipole moment (debye) | LogP | No. | Compound | Dipole moment (debye) | LogP |
|---|---|---|---|---|---|---|---|
| C-01 | 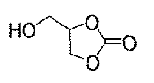 | 4.72 | -1.55 | C-10 | 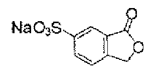 | 5.61 | -1.18 |
| C-02 | 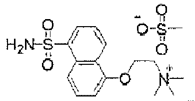 | 11.15 | -2.23 | C-11 | 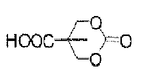 | 5.19 | 0.04 |
| C-03 | 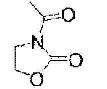 | 7.31 | -0.31 | C-12 | 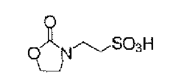 | 5.89 | -1.96 |
| C-04 | 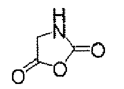 | 5.24 | -1.03 | C-13 | 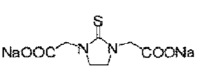 | 12.66 | -0.68 |
| C-05 | 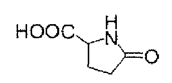 | 4.08 | -1.15 | C-14 | 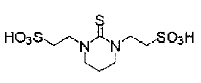 | 8.69 | -2.84 |
| C-06 | 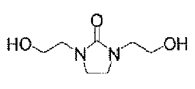 | 6.90 | -1.01 | C-15 | 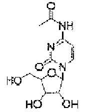 | 8.84 | -2.04 |
| C-07 | 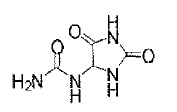 | 4.06 | -2.24 | C-16 | 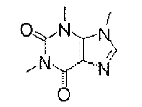 | 7.01 | -0.04 |
| C-08 | 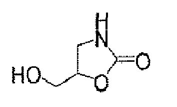 | 4.49 | -1.44 | C-17 | 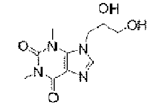 | 5.11 | -1.29 |
| C-09 | 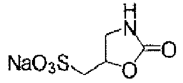 | 7.76 | -1.88 | C-18 | 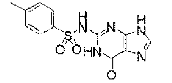 | 6.96 | 0.65 |
| C-19 | 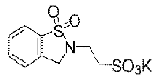 | 6.79 | 0.15 | C-28 | 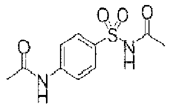 | 7.90 | -0.75 |
| C-20 | 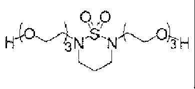 | 5.66 | -1.16 | C-29 | 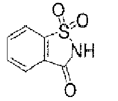 | 4.11 | 0.72 |
| C-21 | 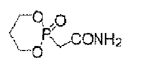 | 8.68 | -1.05 | C-30 | 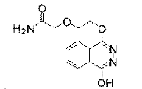 | 6.90 | 0.63 |
| C-22 | 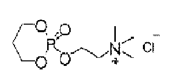 | 12.92 | -3.82 | C-31 | 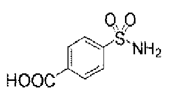 | 5.12 | 0.45 |
| C-23 | 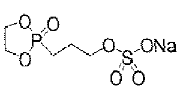 | 7.16 | -1.14 | C-32 | 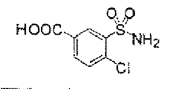 | 3.94 | 0.96 |
| C-24 | 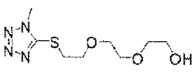 | 6.43 | -0.60 | C-33 | 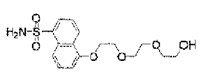 | 5.73 | 0.70 |
| C-25 | 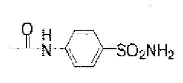 | 5.45 | -0.35 | C-34 | 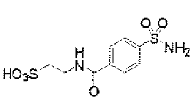 | 7.56 | -2.23 |
| C-26 | 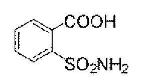 | 6.08 | 0.45 | C-35 | 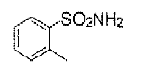 | 4.40 | 0.80 |
| C-27 | 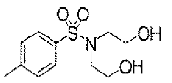 | 5.69 | 0.86 | C-36 | 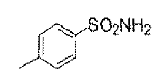 | 5.44 | 0.80 |
| C-37 | 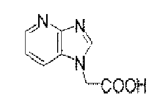 | 6.18 | -0.13 | | | | |
| C-38 | 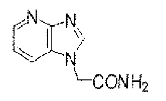 | 8.43 | -0.87 | | | | |
| C-39 | 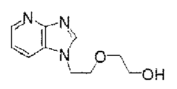 | 5.87 | -0.29 | | | | |
| C-40 | 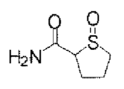 | 3.91 | -1.70 | | | | |
| C-41 | 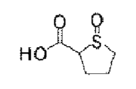 | 4.53 | 0.87 | | | | |

The compound represented by Formulae (1) to (5) may be used singly or in a combination of two or more types.

As the compound represented by Formulae (1) to (5), any of the above-mentioned compounds may suitably be used; a compound represented by Formulae (1) to (4) is preferable, and a compound represented by Formulae (1) to (3) is particularly preferable.

The amount of compound represented by Formulae (1) to (5) added to the photosensitive layer is preferably 0.1 to 50 wt % relative to the total solids content of the photosensitive layer, more preferably 0.5 to 20 wt %, and particularly preferably 1.0 to 10 wt %.

Each of the components constituting a photosensitive composition forming a photosensitive layer of the lithographic printing plate precursor related to the present invention is explained below.

### (E) Colorant

The photosensitive layer preferably employs a pigment having a large absorption in the visible light region. Specific examples of the dye include Oil Yellow #101, Oil Yellow #103, Oil Pink #312, Oil Green BG, Oil Blue BOS, Oil Blue #603, Oil Black BY, Oil Black BS, Oil Black T-505 (all from Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247.

As the colorant, a pigment is preferably used.

As the pigment, a pigment such as a phthalocyanine-based pigment, an azo-based pigment, carbon black, or titanium oxide may suitably be used, and a phthalocyanine-based pigment is most preferably used.

It is preferable to add these colorants because the image area and the non-image area after image formation can be easily differentiated. The amount of colorant added is preferably 0.01 to 10 wt % relative to the total solids content of the photosensitive layer.

### (F) Sensitizing dye

The photosensitive layer preferably contains a sensitizing dye. Adding, for example, a sensitizing dye having a maximum absorption at 300 to 450 nm, a sensitizing dye having a maximum absorption at 500 to 600 nm, or an IR absorber having a maximum absorption at 750 to 1,400 nm enables a high sensitivity lithographic printing plate precursor corresponding to a 405 nm violet laser, a 532 nm green laser, or an 803 nm IR laser, which are usually used in the present field, to be provided.

The sensitizing dye having a maximum absorption in the wavelength region of 350 to 450 nm is first explained.

Examples of such a sensitizing dye include a merocyanine dye, a benzopyran, a coumarin, an aromatic ketone, and an anthracene.

Among sensitizing dyes having an absorption maximum in the wavelength region of 350 to 450 nm, from the viewpoint of high sensitivity a dye represented by Formula (F-1) below is preferable. 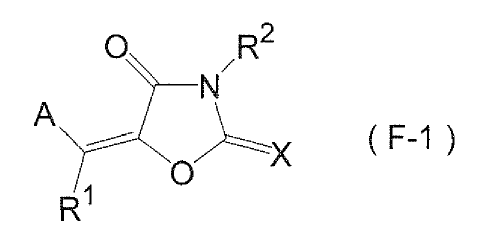 (In Formula (F-1), A denotes an optionally substituted aromatic ring group or heterocyclic group, X denotes an oxygen atom, a sulfur atom, or NR³, R¹, R², and R³ independently denote a monovalent non-metallic atomic group, and A and R¹, and R² and R₃ may be bonded to each other to form an aliphatic or aromatic ring.)

Formula (F-1) is explained in further detail.

R¹, R², and R³ in Formula (F-1) are independently a monovalent non-metallic atomic group, and preferably a hydrogen atom, a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group, or a halogen atom.

A in Formula (F-1) is now explained.

A denotes an optionally substituted aromatic ring group or heterocyclic group, and specific examples of the optionally substituted aromatic ring or heterocycle include the same as those described for R¹, R², and R³ in Formula (F-1).

Preferred specific examples of such a sensitizing dye include compounds described in paragraphs 0047 to 0053 of JP-A-2007-58170.

Furthermore, a sensitizing dye represented by Formulae (F-2) to (F-4) below may also be used.

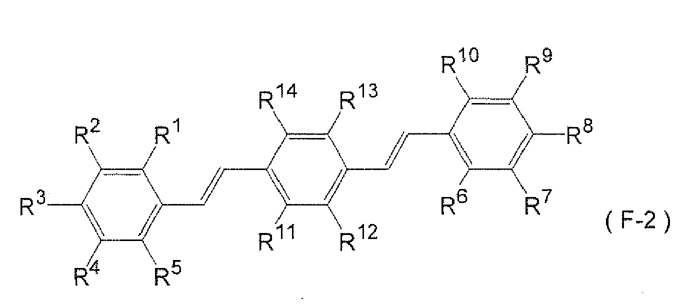

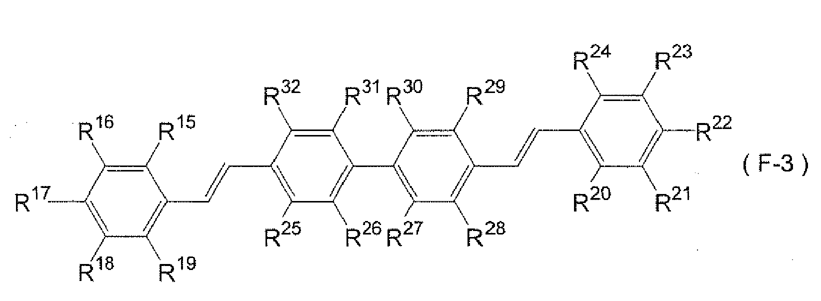

In Formula (F-2), R¹ to R¹⁴ independently denote a hydrogen atom, an alkyl group, an alkoxy group, a cyano group, or a halogen atom. At least one of R¹ to R¹⁰ denotes an alkoxy group having 2 or more carbons.

In Formula (F-3), R¹⁵ to R³² independently denote a hydrogen atom, an alkyl group, an alkoxy group, a cyano group, or a halogen atom. At least one of R¹⁵ to R²⁴ denotes an alkoxy group having 2 or more carbons.

Examples thereof include compounds described in EP No. 1,349,006 and WO 2005/029187.

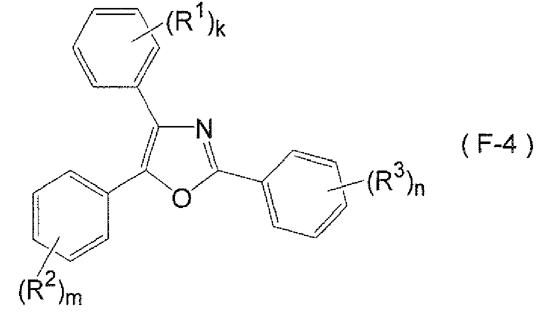

In Formula (F-4), R¹, R², and R³ independently a halogen atom, an alkyl group, an aryl group, an aralkyl group, an -NR⁴R⁵ group, or an -OR⁶ group, R⁴, R⁵, and R⁶ independently denote a hydrogen atom, an alkyl group, an aryl group, or an aralkyl group, and k, m, and n independently denote an integer of 0 to 5.

Examples thereof include compounds described in EP No. 1,868,036 and WO 2004/074930.

Furthermore, sensitizing dyes described in JP-A-2007-171406, JP-A-2007-206216, JP-A-2007-206217, JP-A-2007-225701, JP-A-2007-225702, JP-A-2007-316582, and JP-A-2007-328243 may also be used.

The amount of sensitizing dye added is preferably 0.05 to 30 parts relative to 100 parts of the total solids content of the photosensitive layer, more preferably 0.1 to 20 parts, and yet more preferably 0.2 to 10 parts.

The sensitizing dye having a maximum absorption at 750 to 1,400 nm (IR absorber) that is suitably used in the present invention is explained in detail below.

The IR absorber used here attains an electronically excited state with high sensitivity by irradiation with (exposure to) an IR laser, and it is surmised that electron transfer, energy transfer, generation of heat (photothermal conversion), etc. related to the electronically excited state acts on a photopolymerization initiator present in the photosensitive layer so as to cause a chemical change of the photopolymerization initiator, thus generating an active species such as a radial, an acid, or a base. Whichever is the case, adding a sensitizing dye having a maximum absorption at 750 to 1,400 nm is particularly suitable for production of a plate that is directly drawn using an IR laser having a wavelength of 750 nm to 1,400 nm, and compared with a conventional lithographic printing plate precursor, high image formation performance can be exhibited.

The IR absorber is preferably a dye or a pigment having an absorption maximum at a wavelength of 750 nm to 1,400 nm.

As the dye, commercial dyes and known dyes described in the literature such as, for example, 'Senryo Binran' (Dye Handbook) (Ed. The Society of Synthetic Organic Chemistry, Japan, 1970) may be used. Specific examples thereof include an azo dye, a metal complex salt azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt, and a metal thiolate complex.

Among these dyes, a cyanine dye, a squarylium dye, a pyrylium salt, a nickel thiolate complex, and an indolenine cyanine dye are preferable, a cyanine dye and an indolenine cyanine dye are more preferable, and a cyanine dye represented by Formula (a) below is particularly preferable.

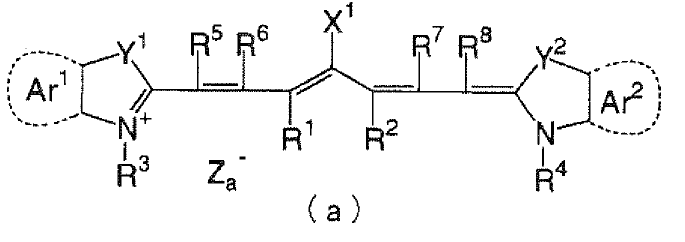

In Formula (a), X¹ denotes a hydrogen atom, a halogen atom, -NPh₂, X²-L¹, or the group shown below.

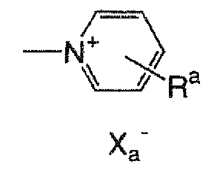

Here, X² denotes an oxygen atom, a nitrogen atom, or a sulfur atom, L¹ denotes a hydrocarbon group having 1 to 12 carbon atoms, a hetero atom-containing aromatic ring, or a hetero atom-containing hydrocarbon group having 1 to 12 carbon atoms. The hetero atom referred to here means N, S, O, a halogen atom, or Se.

Xₐ⁻ is defined in the same manner as for Zₐ⁻, which is described later, and five R^{a}s independently denote a hydrogen atom or a substituent selected from the group consisting of an alkyl group, an aryl group, a substituted or unsubstituted amino group, and a halogen atom.

R¹ and R² independently denote a hydrocarbon group having 1 to 12 carbon atoms. From the viewpoint of storage stability of a photosensitive layer coating liquid, R¹ and R² are preferably hydrocarbon groups having two or more carbon atoms, or R¹ and R² to be bonded to each other to form a 5-membered ring or a 6-membered ring.

Ar¹ and Ar² may be identical to or different from each other, and denote an optionally substituted aromatic hydrocarbon group. Preferred examples of the aromatic hydrocarbon group include a benzene ring and a naphthalene ring. Preferred examples of the substituent include a hydrocarbon group having no greater than 12 carbon atoms, a halogen atom, and an alkoxy group having no greater than 12 carbon atoms.

Y¹ and Y² may be identical to or different from each other, and denote a sulfur atom or a dialkylmethylene group having no greater than 12 carbon atoms.

R³ and R⁴ may be identical to or different from each other, and denote an optionally substituted hydrocarbon group having no greater than 20 carbon atoms. Preferred examples of the substituent include an alkoxy group having no greater than 12 carbon atoms, a carboxy group, and a sulfo group.

R⁵, R⁶, R⁷, and R⁸ may be identical to or different from each other, and denote a hydrogen atom or a hydrocarbon group having no greater than 12 carbon atoms. From the availability of starting materials, a hydrogen atom is preferable.

Furthermore, Zₐ⁻ denotes a counteranion. When a cyanine dye represented by Formula (a) has an anionic substituent in its structure and neutralization of charge is unnecessary, Zₐ⁻ is not required. From the viewpoint of storage stability of the photosensitive layer coating liquid, Zₐ⁻ is preferably a halogen ion, a perchlorate ion, a tetrafluoroborate ion, a hexafluorophosphate ion, or a sulfonate ion, and particularly preferably a perchlorate ion, a hexafluorophosphate ion, or an arylsulfonate ion. As a counterion, one not containing a halogen ion is particularly preferable.

As a pigment, commercial pigments and pigments described in 'Karaa Indekkusu' (C.I.) Binran (Handbook), 'Saishin Ganryo Binran' (Latest Pigments Handbook) (Ed. Nippon Ganryo Gijutsu Kyokai, 1977), 'Saishin Ganryo Ouyo Gijutsu' (Latest Pigment Application Techniques' (CMC Publishing, 1986), and 'Insatsu Inki Gijutsu' (Printing Ink Techniques) (CMC Publishing, 1984) may be used.

Examples of the type of pigment include a black pigment, a yellow pigment, an orange pigment, a brown pigment, a red pigment, a purple pigment, a blue pigment, a green pigment, a fluorescent pigment, a metal powder pigment and, in addition, polymer-binding dyes. Specifically, an insoluble azo pigment, an azo lake pigment, a condensed azo pigment, a chelate azo pigment, a phthalocyanine type pigment, an anthraquinone type pigment, perylene and perinone type pigments, a thioindigo type pigment, a quinacridone type pigment, a dioxazine type pigment, an isoindolinone type pigment, a quinophthalone type pigment, a dye lake pigment, an azine pigment, a nitroso pigment, a nitro pigment, a natural pigment, a fluorescent pigment, an inorganic pigment, carbon black, etc. may be used. Among these pigments, carbon black is preferable.

These pigments may be used with or without a surface treatment being carried out. As a method for the surface treatment, a method in which the surface is coated with a resin or wax, a method in which a surfactant is deposited, a method in which a reactive material (e.g. a silane coupling agent, an epoxy compound, a polyisocyanate, etc.) is bonded to the pigment surface, etc. can be considered. The above-mentioned surface treatment methods are described in 'Kinzoku Sekken no Seishitsu to Ouyo' (Properties and Applications of Metal Soaps) (SAIWAISHOBO), 'Insatsu Inki Gijutsu' (Printing Ink Techniques) (CMC Publishing, 1984), and 'Saishin Ganryo Ouyo Gijutsu' (Latest Pigment Application Techniques) (CMC Publishing, 1986).

The particle size of the pigment is preferably in the range of 0.01 µm to 10 µm, more preferably in the range of 0.05 µm to 1 µm, and particularly preferably in the range of 0.1 µm to 1 µm. When in this preferred particle size range, the dispersion stability of the pigment in the photosensitive layer is excellent and a uniform photosensitive layer can be obtained.

As a method for dispersing the pigment, a known dispersion technique used for ink production, toner production, etc. may be used. Examples of a dispersion machine include an ultrasonic disperser, a sand mill, an attritor, a pearl mill, a super mill, a ball mill, an impeller, a disperser, a KD mill, a colloidal mill, a dynatron, a three roll mill, and a pressure kneader. Details are described in 'Saishin Ganryo Ouyo Gijutsu' (Latest Pigment Application Techniques) (CMC Publishing, 1986).

These IR absorbers may be added to the same layer as other components or may be added to another layer provided separately.

From the viewpoint of uniformity in the photosensitive layer and durability of the photosensitive layer, the amount of these IR absorbers added is preferably 0.01 to 50 wt % relative to the total content of solids forming the photosensitive layer, and more preferably 0.1 to 10 wt %; in the case of a dye it is particularly preferably 0.5 to 10 wt %, and in the case of a pigment it is particularly preferably 0.1 to 10 wt %.

### (G) Microcapsules

In the present invention, as a method by which the above-mentioned constituents of the photosensitive layer and other constituents described hereinafter are contained in the photosensitive layer, part of the constituents may be encapsulated in microcapsules and added to the photosensitive layer as described in, for example, JP-A-2001-277740 and JP-A-2001-277742. In such a case, each constituent may be present inside or outside the microcapsule in any appropriate ratio.

As a method of microencapsulating the constituents of the photosensitive layer, known methods can be used.

Methods for the production of microcapsules include, for example, a method utilizing coacervation described in U.S. Pat. Nos. 2,800,457 and 2,800,458, a method using interfacial polymerization described in U.S. Pat. No. 3,287,154, JP-B-38-19574, and JP-B-42-446, a method using polymer deposition described in U.S. Pat. Nos. 3,418,250 and 3,660,304, a method using an isocyanate polyol wall material described in U.S. Pat. No. 3,796,669, a method using an isocyanate wall material described in U.S. Pat. No. 3,914,511, a method using a urea-formaldehyde type or urea-formaldehyde-resorcinol type wall-forming material described in U.S. Pat. Nos. 4,001,140, 4,087,376, and 4,089,802, a method using a wall material, for example, a melamine-formaldehyde resin or hydroxycellulose described in U.S. Pat. No. 4,025,445, an in-situ method by monomer polymerization described in JP-B-36-9163 and JP-B-51-9079, a spray drying method described in GB Patent No. 930,422 and U.S. Pat. No. 3,111,407, and an electrolytic dispersion cooling method described in GB Patents Nos. 952,807 and 967,074, but the present invention should not be construed as being limited thereto.

A preferred microcapsule wall used in the present invention has three-dimensional crosslinking and has the property of being swollen by solvent. From this point of view, preferred wall materials of the microcapsule include water-insoluble polymer such as polyurea, polyurethane, polyester, polycarbonate, polyamide, and mixtures thereof, and polyurea and polyurethane are particularly preferred. Furthermore, a compound having a crosslinkable functional group such as an ethylenically unsaturated bond, capable of being introduced into above-mentioned water-insoluble polymer, may be introduced into the microcapsule wall.

The average particle size of the microcapsules is preferably 0.01 to 3.0 µm, more preferably 0.05 to 2.0 µm, and particularly preferably 0.10 to 1.0 µm. When in the above-mentioned range, good resolution and stability over time can be achieved.

### (H) Other photosensitive layer components

The photosensitive layer may further contain various additives as necessary. As the additive, a surfactant for promoting developability and improving coated surface conditions, a hydrophilic polymer for improving developability and improving dispersion stability of microcapsules, a printing out agent for making visible an image area and a non-image area, a polymerization inhibitor for inhibiting unwanted thermal polymerization of a radically polymerizable compound during production or storage of a photosensitive layer, a higher fatty derivative for preventing polymerization inhibition by oxygen, inorganic particles for improving cured film strength of an image area, a hydrophilic low molecular weight compound for improving developability, a co-sensitizer or a chain transfer agent for improving sensitivity, a plasticizer for improving plasticity, etc. may be added. These compounds may employ known substances such as compounds described in, for example, JP-A-2007-171406, JP-A-2007-206216, JP-A-2007-206217, JP-A-2007-225701, JP-A-2007-225702, JP-A-2007-316582, and JP-A-2007-328243.

As a surfactant that is preferably used in the present invention, there can be cited a fluorine-based surfactant containing a perfluoroalkyl group in the molecule. Examples of such a fluorine-based surfactant include an anionic type such as a perfluoroalkylcarboxylic acid salt, a perfluoroalkylsulfonic acid salt, or a perfluoroalkylphosphoric acid ester; an amphoteric type such as a perfluoroalkylbetaine; a cationic type such as a perfluoroalkyltrimethylammonium salt; and a nonionic type such as a perfluoroalkylamine oxide, a perfluoroalkyl ethylene oxide adduct, an oligomer containing a perfluoroalkyl group and a hydrophilic group, an oligomer containing a perfluoroalkyl group and a lipophilic group, an oligomer containing a perfluoroalkyl group, a hydrophilic group, and a lipophilic group, or a urethane containing a perfluoroalkyl group and a lipophilic group. Furthermore, a fluorine-based surfactant described in JP-A-62-170950, JP-A-62-226143, or JP-A-60-168144 may also be suitably cited.

The surfactant may be used singly or in a combination of two or more types. The content of the surfactant is preferably 0.001 to 10 wt % of the total solids content of the photosensitive layer, and more preferably 0.01 to 7 wt %.

As a compound functioning as a chain transfer agent, a group of compounds having SH, PH, SiH, or GeH in the molecules may be used. These compounds can donate hydrogen to a low activity radical species to generate a radical or are oxidized and then deprotonated to generate a radical.

The photosensitive layer in the present invention may preferably employ as a chain transfer agent a thiol compound (e.g. a 2-mercaptobenzimidazole, a 2-mercaptobenzothiazole, a 2-mercaptobenzoxazole, a 3-mercaptotriazole, a 5-mercaptotetrazole, etc.) in particular.

Among them, a thiol compound represented by Formula (S) below is particularly suitably used. In accordance with the use of a thiol compound represented by Formula (S) as a chain transfer agent, degradation of sensitivity due to evaporation from the photosensitive layer or diffusion to another layer can be avoided, the storage stability is excellent, and a lithographic printing plate precursor having high sensitivity and high plate life can be obtained.

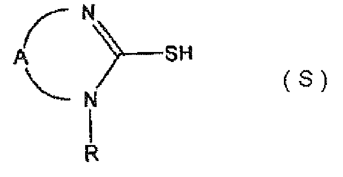

In Formula (S), R denotes an optionally substituted alkyl group or an optionally substituted aryl group, A denotes an atomic group forming together with the N=C-N moiety a carbon atom-containing 5- or 6-membered heterocycle, and A may further have a substituent.

### Formation of Photosensitive Layer

The photosensitive layer is formed by dispersing or dissolving each of the necessary components described above in a solvent to prepare a coating liquid and applying the liquid.

As the solvent used here, there can be cited for example ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, *N,N*-dimethylacetamide, *N,N*-dimethylformamide, tetramethylurea, N-methylpyrrolidone, dimethylsulfoxide, sulfolane, γ-butyrolactone, toluene, and water, but the present invention should not be construed as being limited thereto. These solvents may be used singly or as a mixture.

The solids content concentration of the coating liquid is preferably 1 to 50 wt %.

The photosensitive layer may also be formed by preparing a plurality of coating liquids by dispersing or dissolving the same or different components described above in the same or different solvents and repeatedly coating and drying a plurality of times.

The amount (solids content) of the photosensitive layer that the support is coated with after coating and drying may be varied depending on the use, but normally it is preferably 0.3 to 3.0 g/m². In the above-mentioned range good sensitivity and good film properties of the photosensitive layer can be obtained.

Various methods can be used for the coating. Examples of the method include bar coater coating, spin coating, spray coating, curtain coating, dip coating, air knife coating, blade coating, and roll coating.

### Protective Layer

In the lithographic printing plate precursor that can be used in the present invention, a protective layer (oxygen-blocking layer) is preferably provided on or above the photosensitive layer in order to prevent diffusion and penetration of oxygen, which inhibits a polymerization reaction at the time of exposure.

The protective layer preferably has an oxygen permeability (A) at 25°C under one atmosphere of 1.0 ≤ (A) ≤ 20 (mL/m²·day). When the oxygen permeability (A) is at least 1.0 (mL/m²·day), an undesirable polymerization reaction can be suppressed during production and during storage before image exposure, and the occurrence of the problems of undesirable fogging or widening of image lines during image exposure can be suppressed. When the oxygen permeability (A) is no greater than 20 (mL/m²·day), the sensitivity is excellent. The oxygen permeability (A) is more preferably in the range of 1.5 ≤ (A) ≤ 12 (mL/m²·day), and yet more preferably in the range of 2.0 ≤ (A) ≤ 10.0 (mL/m²·day).

Apart from the above-mentioned oxygen permeability, as properties required of the protective layer it is desirable that the protective layer does not substantially hinder the transmission of light used for exposure, has excellent adhesion to the photosensitive layer, and can be easily removed during a development step after exposure. Protective layers have already been devised and described in detail in U.S. Pat. No. 3,458,311 and JP-B-55-49729.

As the material that can be used for the protective layer, for example, a water-soluble polymer compound with relatively good crystallinity is preferably used. Specifically, a water-soluble polymer such as polyvinyl alcohol (PVA), a vinyl alcohol/vinyl phthalate copolymer, a vinyl acetate/vinyl alcohol/vinyl phthalate copolymer, a vinyl acetate/crotonic acid copolymer, polyvinylpyrrolidone, an acidic cellulose, gelatin, gum Arabic, polyacrylic acid, or polyacrylamide can be cited. The water-soluble polymer compound may be used singly or as a mixture. Of these compounds, it is preferable to use polyvinyl alcohol as a main component since the best results can be obtained in fundamental properties such as oxygen-blocking properties and development removability.

The polyvinyl alcohol for use in the protective layer may be partially substituted with ester, ether or acetal as long as it contains unsubstituted vinyl alcohol units for achieving the necessary oxygen-blocking properties and water solubility. In the same way, part of the polyvinyl alcohol may have another copolymer component.

As specific examples of the polyvinyl alcohol, those with 71 to 100 mol % hydrolysis and 300 to 2,400 polymerization repeating units can be cited.

Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (Kuraray Co., Ltd.). They can be used singly or as a mixture. In a preferred embodiment, the polyvinyl alcohol content in the protective layer is 20 to 95 wt %, and more preferably 30 to 90 wt %.

Furthermore, a known modified polyvinyl alcohol may also be preferably used. For example, polyvinyl alcohols of various degrees of polymerization having at random various types of hydrophilic modified sites such as an anion-modified site modified with an anion such as a carboxy group or a sulfo group, a cation-modified site modified with a cation such as an amino group or an ammonium group, a silanol-modified site, and a thiol-modified site, and polyvinyl alcohols of various degrees of polymerization having at the terminal of the polymer chain various types of modified sites such as the above-mentioned anion-modified site, the above-mentioned cation-modified site, a silanol-modified site, and a thiol-modified site and, furthermore, an alkoxy-modified site, a sulfide-modified site, an ester-modified site of vinyl alcohol with various types of organic acids, an ester-modified site of the above-mentioned anion-modified site with an alcohol, and an epoxy-modified site can be cited.

As a component used as a mixture with polyvinyl alcohol, polyvinylpyrrolidone or a modified product thereof is preferable from the viewpoint of oxygen-blocking properties and development removability. The content thereof in the protective layer is preferably 3.5 to 80 wt %, more preferably 10 to 60 wt %, and yet more preferably 15 to 30 wt %.

The components of the protective layer (PVA selection and use of additives), the amount coated, etc. are determined taking into consideration fogging properties, adhesion, and scratch resistance in addition to oxygen-blocking properties and development removability. In general, the higher the degree of hydrolysis of the PVA used (the higher the unsubstituted vinyl alcohol unit content in the protective layer) and the thicker the film thickness, the higher are the oxygen-blocking properties, which is advantageous from the viewpoint of sensitivity.

The molecular weight of the (co)polymer of the above-mentioned polyvinyl alcohol (PVA), etc. is preferably 2,000 to 10,000,000 and more preferably 20,000 to 3,000,000.

As other components of the protective layer, glycerol, dipropylene glycol, etc. can be added in an amount corresponding to several wt % of the (co)polymer to impart flexibility. Furthermore, an anionic surfactant such as a sodium alkylsulfate or sodium alkylsulfonate; an amphoteric surfactant such as an alkylaminocarboxylic acid salt or an alkylaminodicarboxylic acid salt; or a nonionic surfactant such as a polyoxyethylene alkyl ether or a polyoxyethylene alkyl phenyl ether can be added in an amount corresponding to several wt % of the (co)polymer.

Furthermore, adhesion to an image area and scratch resistance are also extremely important for handling of a plate. That is, when a hydrophilic layer comprising a water-soluble polymer is layered on an oleophilic photosensitive layer, layer peeling due to insufficient adhesion is liable to occur, and the peeled portion causes defects such as incomplete film curing due to polymerization inhibition by oxygen. Various proposals have been made for improving the adhesion between these two layers. For example, U.S. patent application Ser. Nos. 292,501 and 44,563 state that sufficient adhesion can be obtained by mixing from 20 to 60 wt % of an acrylic-based emulsion or a water-insoluble vinylpyrrolidone/vinyl acetate copolymer with a hydrophilic polymer mainly comprising polyvinyl alcohol and layering the resulting mixture on the photosensitive layer. Any of these known techniques may be applied to the protective layer according to the present invention. Coating methods for such a protective layer are described in detail, for example, in U.S. Pat. No. 3,458,311 and JP-B-55-49729.

Furthermore, it is also preferable for an inorganic stratiform compound to be contained in the protective layer of the lithographic printing plate precursor for the purpose of improving the oxygen-blocking properties and the photosensitive layer surface protection properties.

The inorganic stratiform compound used here is a particle having a thin tabular shape and includes, for example, mica, for example, natural mica represented by the following formula:

A(B,C)₂₋₅D₄O₁₀(OH,F,O)₂

(in the formula A denotes any one of K, Na, and Ca, B and C denote any one of Fe (II), Fe(III), Mn, Al, Mg, and V, and D denotes Si or Al) or synthetic mica; talc represented by the following formula: 3MgO·4SiO·H₂O; taeniolite; montmorillonite; saponite; hectorite; and zirconium phosphate.

Of the inorganic stratiform compounds, fluorine-based swellable synthetic mica, which is a synthetic inorganic stratiform compound, is particularly useful in the present invention.

The aspect ratio of the inorganic stratiform compound is preferably at least 20, more preferably at least 100, and yet more preferably at least 200. The aspect ratio is the ratio of thickness to major axis of a particle and can be determined, for example, from a projection drawing of a particle by microphotography. The larger the aspect ratio, the greater the effect obtained.

As for the particle size of the inorganic stratiform compound, the average major axis is preferably 0.3 to 20 µm, more preferably 0.5 to 10 µm, and yet more preferably 1 to 5 µm. The average thickness of the particle is preferably no greater than 0.1 µm, more preferably no greater than 0.05 µm, and yet more preferably no greater than 0.01 µm. For example, in the swellable synthetic mica that is a representative compound of the inorganic stratiform compound, the thickness is on the order of from 1 to 50 nm and the plane size is on the order of from 1 to 20 µm.

When such an inorganic stratiform compound particle having a large aspect ratio is contained in the protective layer, the coated film strength increases and, furthermore, since penetration of oxygen or moisture can be inhibited effectively deterioration of the protective layer due to deformation, etc. can be prevented, and even when the lithographic printing plate precursor is stored for a long period of time under high humidity conditions there is no degradation in the image-forming properties thereof due to change in humidity and the storage stability is excellent.

The content of the inorganic stratiform compound in the protective layer is preferably 5/1 to 1/100 as a ratio by weight relative to the amount of binder used in the protective layer. When a plurality of inorganic stratiform compounds are used in combination, it is also preferable that the total amount of the inorganic stratiform compounds is in the above-mentioned weight ratio range.

A method for dispersing the inorganic stratiform compound used in the protective layer may employ a method described in JP-A-2007-171406, JP-A-2007-206216, JP-A-2007-206217, JP-A-2007-225701, JP-A-2007-225702, JP-A-2007-316582, JP-A-2007-328243, etc.

The coat weight of the protective layer is preferably in the range of 0.05 to 10 g/m² as a coat weight after drying. When the protective layer contains the inorganic stratiform compound, it is more preferably in the range of 0.1 to 1.0 g/m², and when the protective layer does not contain the inorganic stratiform compound, it is more preferably in the range of 0.5 to 5 g/m².

### Support

The support used for the lithographic printing plate precursor of the present invention is not particularly limited, and a dimensionally stable sheetform hydrophilic support may be used. Examples of materials forming the support include paper, paper laminated with a plastic (e.g. polyethylene, polypropylene, polystyrene, etc.), a metal sheet (e.g. aluminum, zinc, copper, etc.), a plastic film (e.g. cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and paper or plastic film on which the above-mentioned metal is laminated or vapor-deposited. Preferred examples of the support include a polyester film and aluminum sheet. Among these, aluminum sheet is particularly preferable since the dimensional stability is good and it is relatively inexpensive.

The aluminum sheet is a pure aluminum sheet, an alloy sheet containing aluminum as a main component and a small amount of a different element, or a thin film of aluminum or an aluminum alloy laminated with a plastic. Examples of the different element contained in the aluminum alloy include silicon, iron, manganese, copper, magnesium, chromium, zinc, bismuth, nickel, and titanium. The content of the different element in the alloy is preferably equal to or less than 10 wt %. In the present invention, a pure aluminum sheet is preferable, but since it is difficult to produce completely pure aluminum because of the refining technique, a trace amount of a different element may be contained. The composition of the aluminum sheet is not specified, and a known generally used material may be utilized as appropriate.

Prior to the aluminum sheet being used, it is preferably subjected to a surface treatment such as a surface roughening treatment or an anodizing treatment. Surface treatment makes it easy to improve the hydrophilicity and ensure that there is good adhesion between the photosensitive layer and the support. Prior to the aluminum sheet being subjected to the surface roughening treatment, it may be subjected as desired to a degreasing treatment using a surfactant, an organic solvent, an aqueous alkaline solution, etc. in order to remove rolling oil on the surface.

The surface roughening treatment for the aluminum sheet surface may be carried out by various types of methods, and examples thereof include a mechanical surface roughening treatment, an electrochemical surface roughening treatment (a surface roughening treatment involving dissolving the surface electrochemically), and a chemical surface roughening treatment (a surface roughening treatment involving selectively dissolving the surface chemically).

As a method for the mechanical surface roughening treatment, a known method such as a ball grinding method, a brush grinding method, a blast grinding method, or a buff grinding method may be used.

As a method for the electrochemical surface roughening treatment, for example, a method in which alternating current or direct current is applied in an electrolyte solution containing an acid such as hydrochloric acid or nitric acid can be cited. It is also possible to employ a method as described in JP-A-54-63902 in which a mixed acid is used.

The aluminum sheet subjected to a surface roughening treatment is subjected as necessary to an alkali etching treatment using an aqueous solution of potassium hydroxide, sodium hydroxide, etc.; furthermore, after neutralization, it may be subjected to an anodizing treatment as desired in order to improve the abrasion resistance.

As an electrolyte that may be used for the anodizing treatment of the aluminum sheet, various types of electrolytes that form a porous oxide film may be used. In general, sulfuric acid, hydrochloric acid, oxalic acid, chromic acid, or a mixed acid thereof may be used. The concentration of the electrolyte may be determined as appropriate according to the type of electrolyte.

Conditions for the anodizing treatment depend on the type of electrolyte used and cannot be specified, but in general the electrolyte solution concentration is 1 to 80 wt %, the solution temperature is 5°C to 70°C, the current density is 5 to 60 A/dm², the voltage is 1 to 100V, and the electrolysis time is 10 sec. to 5 min. The amount of anodized film formed is preferably 1.0 to 5.0 g/m², and more preferably 1.5 to 4.0 g/m². It is preferable for it to be in this range since good plate life and good scratch resistance of a non-image area of a lithographic printing plate can be obtained.

As the support, a substrate that has been subjected to the above-mentioned surface treatment and has an anodized film may be used as it is, but in order to further improve the adhesion to the upper layer, and the hydrophilicity, the contamination resistance, heat-insulating properties, etc., the substrate may appropriately be subjected as necessary to a treatment for enlarging micropores of the anodized film, a sealing treatment, or a surface hydrophilization treatment involving immersion in an aqueous solution containing a hydrophilic compound, which are described in JP-A-2001-253181 or JP-A-2001-322365. These enlarging and sealing treatments are not limited to those described therein, and any conventionally known methods may be employed.

The sealing treatment may be vapor sealing, a treatment with an aqueous solution containing an inorganic fluorine compound such as a single treatment with fluorozirconic acid or a treatment with sodium fluoride, vapor sealing with added lithium chloride, or a sealing treatment with hot water.

Among these, the sealing treatment with an aqueous solution containing an inorganic fluorine compound, the sealing treatment with vapor, and the sealing treatment with hot water are preferable.

With regard to a hydrophilization treatment, there is an alkali metal silicate method, as disclosed in U.S. Pat. Nos. 2,714,066, 3,181,461, 3,280,734, and 3,902,734. In this method, a support is immersed in an aqueous solution of sodium silicate, etc., or subjected to electrolysis. In addition, there is a method in which a support is treated with potassium fluorozirconate, as described in JP-B-36-22063, and a method in which a support is treated with polyvinylphosphonic acid, as described in U.S. Pat. Nos. 3,276,868, 4,153.461, and 4,689,272.

When a support having insufficient surface hydrophilicity such as a polyester film is used as a support, it is preferable to coat the surface with a hydrophilic layer so as to make the surface hydrophilic.

As the hydrophilic layer, a hydrophilic layer, described in JP-A-2001-199175, formed by coating with a coating liquid containing a colloid of an oxide or hydroxide of at least one element selected from the group consisting of beryllium, magnesium, aluminum, silicon, titanium, boron, germanium, tin, zirconium, iron, vanadium, antimony, and a transition metal, a hydrophilic layer, described in JP-A-2002-79772, having an organic hydrophilic matrix obtained by crosslinking or pseudo-crosslinking an organic hydrophilic polymer, a hydrophilic layer having an inorganic hydrophilic matrix obtained by sol-gel exchange involving dehydration and condensation reactions of a polyalkoxysilane, titanate, zirconate or aluminate, or a hydrophilic layer formed from an inorganic thin film having a surface containing a metal oxide is preferable. Among them, a hydrophilic layer formed by coating with a coating liquid containing a colloid of an oxide or hydroxide of silicon is preferable.

Furthermore, when a polyester film, etc. is used as a support, it is preferable to provide an antistatic layer on a hydrophilic layer side, the opposite side, or both sides of the support. When an antistatic layer is provided between the support and a hydrophilic layer, it also contributes to an improvement in adhesion to the hydrophilic layer. As an antistatic layer, a polymer layer, described in JP-A-2002-79772, in which metal oxide microparticles or a matting agent are dispersed, etc. may be used.

The support preferably has a thickness of 0.1 to 0.6 mm, more preferably 0.15 to 0.4 mm, and yet more preferably 0.2 to 0.3 mm.

The support preferably has a center line average roughness of 0.10 to 1.2 µm. When in the above-mentioned range, good adhesion to the photosensitive layer, good plate life, and good stain resistance can be obtained.

Moreover, the color density of the support is preferably 0.15 to 0.65 as a reflection density value. When in the above-mentioned range, it is possible to obtain good image formation properties by preventing halation during imagewise exposure and to obtain good ease of plate inspection after development.

### Undercoat layer

With regard to the lithographic printing plate precursor, it is preferable to provide a support with an undercoat layer of a compound containing a polymerizable group.

When an undercoat layer is used, the photosensitive layer is provided on or above the undercoat layer. The undercoat layer has the effects of strengthening adhesion between the support and the photosensitive layer in exposed areas and facilitating separation of the photosensitive layer from the support in unexposed areas, so that the developability can be improved.

Specific preferred examples of the undercoat layer include a silane coupling agent having an addition-polymerizable ethylenic double bond reactive group described in JP-A-10-282679, and a phosphorus compound having an ethylenic double bond reactive group described in JP-A-2-304441. A particularly preferred compound is a compound having both a polymerizable group such as a methacrylic group or an allyl group and a support-adsorptive group such as a sulfonic acid group, a phosphoric acid group, or a phosphoric acid ester group. A compound having a hydrophilicity-imparting group such as an ethylene oxide group, in addition to the polymerizable group and the support-adsorptive group may also be cited as a preferable compound.

The coat weight (solids content) of the undercoat layer is preferably 0.1 to 100 mg/m², and more preferably 1 to 30 mg/m².

### Backcoat layer

After applying a surface treatment to the support or forming the undercoat layer above the support, a backcoat layer may as necessary be provided on the back surface of the support.

As the backcoat layer, there can preferably be cited, for example, a coating layer comprising an organic polymer compound described in JP-A-5-45885, and a coating layer comprising a metal oxide obtained by hydrolysis and polycondensation of an organic metal compound or an inorganic metal compound described in JP-A-6-35174. Among them, use of an alkoxy compound of silicon such as Si(OCH₃)₄, Si(OC₂H₅)₄, Si(OC₃H₇)₄, or Si(OC₄H₉)₄ is preferable since starting materials are inexpensive and readily available. II. Process for producing lithographic printing plate, and lithographic printing plate

The process for producing a lithographic printing plate of the present invention comprises an exposure step of imagewise exposing with a laser the lithographic printing plate precursor of the present invention, and a development step of removing the photosensitive layer of a non-exposed portion in the presence of an aqueous developer having a pH of 2 to 11. Furthermore, the lithographic printing plate of the present invention is produced by the process for producing a lithographic printing plate of the present invention.

Moreover, with regard to the process for producing a lithographic printing plate of the present invention, the development step is preferably a step in which removal of the protective layer, development processing, and a gumming treatment are carried out at the same time using a single liquid. Furthermore, with regard to the process for producing a lithographic printing plate of the present invention, it is preferable not to carry out a water washing step either prior to or subsequent to the development step. The exposure step and the development step are explained below.

### Exposure step

Process for producing lithographic printing plate of the present invention comprises an exposure step of imagewise exposing with a laser the lithographic printing plate precursor of the present invention.

Prior to the development step, the lithographic printing plate precursor is laser-exposed through a transparent original having a line image, a halftone dot image, etc., or imagewise exposed, for example, by laser beam scanning based on digital data.

A preferred wavelength of a light source is 350 nm to 450 nm or 700 nm to 1,200 nm. When it is 350 nm to 450 nm a lithographic printing plate precursor having a photosensitive layer containing a sensitizing dye having an absorption maximum in this region is used, and when it is 700 nm to 1,200 nm a lithographic printing plate precursor comprising an IR absorber, which is a sensitizing dye having an absorption maximum in this region, is used. As a light source for 350 nm to 450 nm, a semiconductor laser is suitable. As a light source for 700 nm to 1,200 nm, a solid laser or semiconductor laser emitting IR rays is suitable. The exposure mechanism may be any of an internal drum system, an external drum system, a flatbed system, etc.

### Development step

The process for producing a lithographic printing plate of the present invention comprises a development step of removing the photosensitive layer of a non-exposed portion in the presence of an aqueous developer having a pH of 2 to 11. The development step is preferably a step in which removal of the protective layer, development processing, and a gumming treatment are carried out at the same time using a single liquid.

As conventional developing processes, there can be cited (1) a method in which development is carried out using a highly alkaline developer (pH greater than 11), and (2) a method in which development is carried out on a printing machine while adding dampening water and/or ink (on-machine development).

In the conventional development step (1) employing the highly alkaline developer (pH greater than 11), a plurality of steps are required in which the protective layer is removed by a water washing pre-step, development is then carried out using a highly alkaline developer, alkali is removed by a water washing post-step, a gumming treatment is carried out by a gumming step, and drying is carried out by a drying step.

On the other hand, the present invention employs a method in which development is carried out using a developer having a pH of 2 to 11, and after the protective layer is removed and the photosensitive layer of the non-exposed portion is removed using such a developer single liquid, the lithographic printing plate precursor can be immediately set on a printing machine, and printing may be carried out.

In the present invention, it is preferable for the developer to comprise a water-soluble polymer compound, and development and gumming are preferably carried out at the same time. In the process for producing a lithographic printing plate of the present invention, since the pH of the developer is 2 to 11, a water washing post-step for removing alkali is not particularly required, and after development and gumming are carried out using a single liquid, drying may be carried out. Furthermore, a water washing pre-step for removing a protective layer is not particularly required, and removal of the protective layer, development, and gumming can be carried out at the same time using a single liquid, which is preferable. Moreover, it is preferable that, subsequent to development and gumming, surplus developer is removed using a squeegee roller, and drying is then carried out.

The development step may be suitably carried out by an automatic processor equipped with supply means for the developer and a rubbing member.

Development of a lithographic printing plate precursor in the present invention may be carried out in accordance with a standard method, preferably at 0°C to 60°C, and more preferably at on the order of 15°C to 40°C, such as, for example, a method in which an exposed photosensitive lithographic printing plate precursor is immersed in a developer and rubbed by a brush or a method in which an exposed photosensitive lithographic printing plate precursor is sprayed with a developer and rubbed by a brush. Furthermore, processing by such an automatic processor is advantageous from the viewpoint of being free from measures against development residue resulting from the protective layer and photosensitive layer encountered in the case of on-machine development.

As the automatic processor there can be cited an automatic processor described in JP-A-2-220061 and JP-A-60-59351 in which a lithographic printing plate precursor after imagewise recording is subjected to a rubbing treatment while being transported, and an automatic processor described in U.S. Pat. Nos. 5,148,746 and 5,568,768 and GB Patent No. 2,297,719 in which a lithographic printing plate precursor after imagewise recording is placed on a cylinder and subjected to a rubbing treatment while rotating the cylinder. Among them, an automatic processor using a rotating brush roller as the rubbing member is particularly preferable.

The rotating brush roller may be appropriately selected by taking account, for example, of the scratch resistance of the image area and the robustness of the support of the lithographic printing plate precursor.

As the rotating brush roller, a known rotating brush roller produced by implanting a brush material in a plastic or metal roller may be used. For example, a rotating brush roller described in JP-A-58-159533 and JP-A-3-100554, or a brush roller described in JU-B-62-167253 (JU-B denotes a Japanese examined utility model application publication), in which a metal or plastic groove-shaped member having implanted in rows therein a brush material is closely radially wrapped around a plastic or metal roller acting as a core, may be used.

As the brush material, a plastic fiber (for example, a polyester-based synthetic fiber such as polyethylene terephthalate or polybutylene terephthalate; a polyamide-based synthetic fiber such as nylon 6,6 or nylon 6,10; a polyacrylic synthetic fiber such as polyacrylonitrile or a polyalkyl (meth)acrylate; or a polyolefin-based synthetic fiber such as polypropylene or polystyrene) may be used. For example, a brush material having a fiber bristle diameter of 20 to 400 µm and a bristle length of 5 to 30 mm may preferably be used.

The outer diameter of the rotating brush roller is preferably 30 to 200 mm, and the peripheral speed at the tip of the brush rubbing the plate surface is preferably 0.1 to 5 m/sec.

Furthermore, it is preferable to use a plurality, that is, two or more, rotating brush rollers.

The direction of rotation of the rotating brush roller may be the same direction or the opposite direction with respect to the transport direction of the lithographic printing plate precursor, but when two or more rotating brush rollers are used in an automatic processor as shown in FIG. 1, it is preferable that at least one rotating brush roller rotates in the same direction and at least one rotating brush roller rotates in the opposite direction. By such an arrangement, the photosensitive layer in the non-image area can be more reliably removed. Furthermore, rocking the rotating brush roller in the rotational axis direction of the brush roller is also effective.

After the development step is carried out, the developer may be dried by natural drying, but it is preferable to provide a drying step employing hot air, etc.

in the present invention, the lithographic printing plate after the rubbing treatment may if desired be subsequently subjected to water washing, a drying treatment, and a de-oleophilization treatment. In the de-oleophilization treatment, a known de-oleophilization liquid can be used.

In the present invention, a developer having a pH of 2 to 11, which is milder than the conventionally used highly alkaline developer, is used. The pH is particularly preferably 3 to 10.5, and more preferably 4 to 10.5.

The developer of the present invention preferably comprises a surfactant. The surfactant that can be used in the present invention may be any of anionic, nonionic, cationic, and amphoteric surfactants.

Examples of the anionic surfactant include a fatty acid salt, an abietic acid salt, a hydroxyalkanesulfonic acid salt, an alkanesulfonic acid salt, a dialkylsulfosuccinic acid salt, a straight-chain alkylbenzenesulfonic acid salt, a branched alkylbenzenesulfonic acid salt, an alkylnaphthalenesulfonic acid salt, an alkylphenoxypolyoxyethylene propylsulfonic acid salt, a polyoxyethylene alkylsulfophenyl ether salt, sodium *N*-methyl-*N*-oleyltaurine, a disodium *N-*alkylsulfosuccinic acid monoamide, a petroleum sulfonic acid salt, sulfated castor oil, sulfated tallow oil, a sulfate ester of a fatty acid alkyl ester, an alkylsulfate ester, a polyoxyethylene alkyl ether sulfate ester, a fatty acid monoglyceride sulfate ester, a polyoxyethylene alkyl phenyl ether sulfate ester, a polyoxyethylene styrylphenyl ether sulfate ester, an alkyl phosphate ester, a polyoxyethylene alkyl ether phosphate ester, a polyoxyethylene alkyl phenyl ether phosphate ester, a partially saponified styrene-maleic anhydride copolymer, a partially saponified olefin-maleic anhydride copolymer, a naphthalenesulfonic acid salt formalin condensate, an aromatic sulfonic acid salt, and an aromatic substituted polyoxyethylenesulfonic acid salt. Among them, a dialkylsulfosuccinic acid salt, an alkylsulfate ester, or an alkylnaphthalenesulfonic acid salt is particularly preferably used.

The cationic surfactant is not particularly limited, and a conventionally known cationic surfactant may be used. Examples thereof include an alkylamine salt, a quaternary ammonium salt, a polyoxyethylene alkylamine salt, and a polyethylene polyamine derivative.

Examples of the nonionic surfactant include a polyethylene glycol type higher alcohol ethylene oxide adduct, an alkylphenol ethylene oxide adduct, an aromatic compound polyethylene glycol adduct, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of an oil or fat, a polypropylene glycol ethylene oxide adduct, a dimethylsiloxane-ethylene oxide block copolymer, a dimethylsiloxane-(propylene oxide-ethylene oxide) block copolymer, a polyhydric alcohol type glycerol fatty acid ester, a pentaerythritol fatty acid ester, sorbitol and sorbitan fatty acid esters, a sucrose fatty acid ester, a polyhydric alcohol alkyl ether, and an alkanolamine fatty acid amide.

In the present invention, a polyethylene glycol type higher alcohol ethylene oxide adduct, an aromatic compound polyethylene glycol adduct, a sorbitol and/or sorbitan fatty acid ester ethylene oxide adduct, a polypropylene glycol ethylene oxide adduct, a dimethylsiloxane-ethylene oxide block copolymer, a dimethylsiloxane-(propylene oxide-ethylene oxide) block copolymer, and a polyhydric alcohol fatty acid ester are preferable.

Furthermore, from the viewpoint of stable solubility in water and turbidity, for the nonionic surfactant the HLB (Hydrophile-Lipophile Balance) value is preferably at least 6, and more preferably at least 8. It is also possible to similarly use acetylene glycol type and acetylene alcohol type oxyethylene adducts, fluorine type, silicone type etc. surfactants. The surfactants may be used on their own or in combination. The content of the surfactant in the developer is preferably 0.01 to 10 wt %, and more preferably 0.01 to 5 wt %.

As is well known in the surfactant field, an amphoteric surfactant is a compound having an anionic portion and a cationic portion in a single molecule, and includes amphoteric surfactants of the amino acid type, betaine type, amine oxide type, etc. As the amphoteric surfactant that can be used in the developer of the present invention, a compound represented by Formula (1) below and a compound represented by Formula (2) below are preferable.

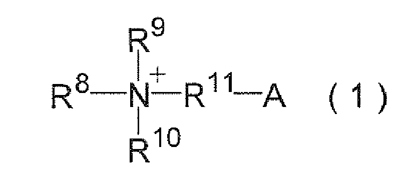

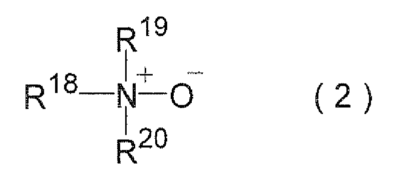

In Formula (1), R⁸ denotes an alkyl group, R⁹ and R¹⁰ independently denote a hydrogen atom or an alkyl group, R¹¹ denotes an alkylene group, and A denotes a carboxylic acid ion or a sulfonic acid ion .

In Formula (2), R¹⁸, R¹⁹, and R²⁰ independently denote a hydrogen atom or an alkyl group, but not all of R¹⁸, R¹⁹, and R²⁰ are hydrogen atoms.

In Formula (1) above, the alkyl group denoted by R⁸, R⁹, or R¹⁰ and the alkylene group denoted by R¹¹ may be a straight chain or a branched chain, may have a linking group in the chain, and may further have a substituent. As the linking group, one containing a hetero atom, such as an ester bond, an amide bond, or an ether bond is preferable.

Furthermore, as the substituent a hydroxy group, an ethylene oxide group, a phenyl group, an amide group, a halogen atom, etc. are preferable.

In the compound represented by Formula (1), when the total number of carbon atoms is large, the hydrophobic portion becomes large, and dissolution in an aqueous developer becomes difficult. In this case there is an improvement by adding a dissolution adjuvant such as an organic solvent, for example, an alcohol, but when the total number of carbon atoms is too large a surfactant sometimes cannot be dissolved in an appropriate mixing range. The total number of carbon atoms for R⁸ to R¹¹ is therefore preferably 8 to 25, and more preferably 11 to 21.

Among R⁸ to R¹⁰, two groups are preferably a hydrogen atom or an alkyl group having 1 to 3 carbon atoms, and more preferably a hydrogen atom or a methyl group.

In Formula (2) above, the alkyl group denoted by R¹⁸, R¹⁹, or R²⁰ may be a straight chain or a branched chain, may have a linking group in the chain, and may further have a substituent. As the linking group, one containing a hetero atom, such as an ester bond, an amide bond, or an ether bond is preferable. Furthermore, as the substituent a hydroxy group, an ethylene oxide group, a phenyl group, an amide group, a halogen atom, etc. are preferable.

In the compound represented by Formula (2), when the total number of carbon atoms is large, the hydrophobic portion becomes large, and dissolution in an aqueous developer becomes difficult. In this case, there is an improvement by adding a dissolution adjuvant such as an organic solvent, for example, an alcohol, but when the total number of carbon atoms is too large a surfactant sometimes cannot be dissolved in an appropriate mixing range. The total number of carbon atoms for R¹⁸ to R²⁰ is therefore preferably 8 to 22, and more preferably 10 to 20.

The total number of carbons of the amphoteric surfactant might depend on the properties of a material used in the photosensitive layer, in particular a binder. In the case of a highly hydrophilic binder, one in which the total number of carbons is relatively small is preferable, and when the binder used has a low degree of hydrophilicity one in which the total number of carbons is large tends to be preferable.

In the present invention, a compound presented by formula (1) can be preferably used.

Preferred specific examples of the amphoteric surfactant that can be used in the developer of the present invention are listed below, but the present invention is not limited thereto.

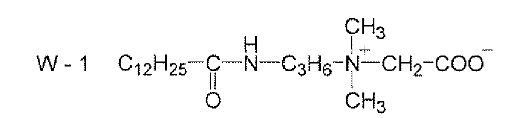

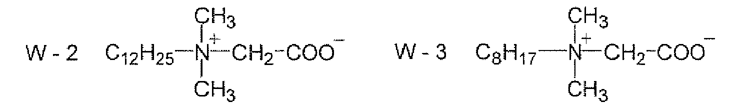

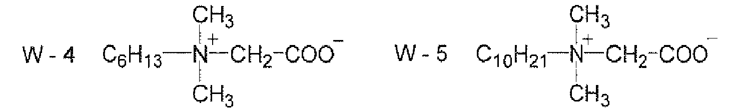

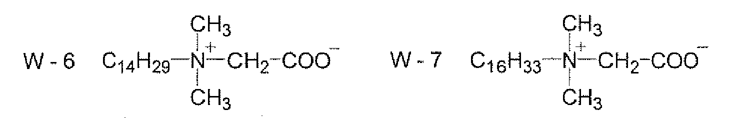

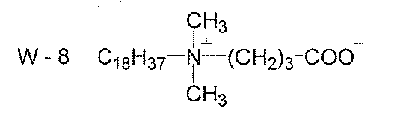

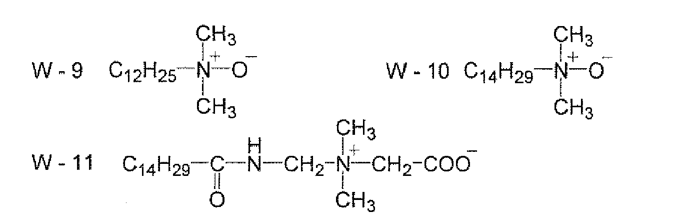

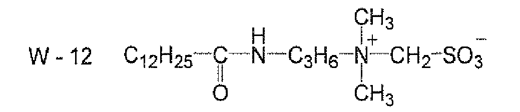

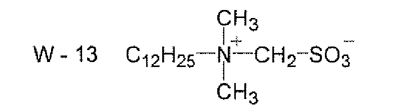

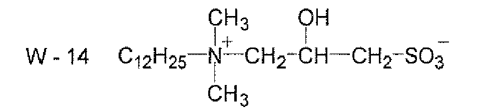

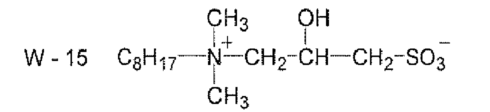

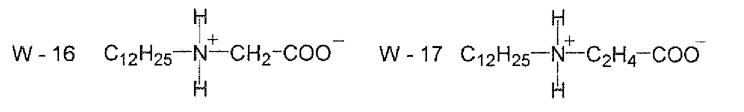

The developer used in the present invention may further contain a pH buffer agent. The pH buffer agent in the present invention may be used without any particular restrictions as long as it is a buffer agent exhibiting a buffer action at a pH of 2 to 11. In the present invention, an alkaline buffer agent is preferably used.

Examples of the pH buffer agent that can be used in the present invention include (a) carbonate ion and hydrogen carbonate ion, (b) borate ion, (c) a water-soluble amine compound and an ion of the amine compound, and the combined use thereof. That is, for example, (a) a combination of carbonate ion-hydrogen carbonate ion, (b) borate ion, or (c) a combination of water-soluble amine compound-ion of the amine compound is preferable since it exhibits a pH buffering action in the developer, can suppress change in pH when the developer is used for a long period of time, and can suppress degradation of developability, the occurrence of development residue, etc. due to change in pH. Furthermore, a combination of carbonate ion and hydrogen carbonate ion is particularly preferable.

In order to make (a) carbonate ion and hydrogen carbonate ion present in the developer, a carbonate salt and a hydrogen carbonate salt may be added to the developer, or carbonate ion and hydrogen carbonate ion may be formed by adjusting the pH after a carbonate salt or a hydrogen carbonate salt is added. The carbonate salt and the hydrogen carbonate salt are not particularly limited, but an alkali metal salt is preferable. As the alkali metal, lithium, sodium, and potassium can be cited, and sodium is particularly preferable. They may be used singly or in a combination of two or more types.

In order to make (b) borate ion present in the developer, after boric acid or a boric acid salt is added to the developer, the pH is adjusted using an alkali or an alkali and an acid, thus forming an appropriate amount of borate ion. The boric acid or the boric acid salt used here is not particularly limited; examples of the boric acid include orthoboric acid, metaboric acid, and tetraboric acid, and among them orthoboric acid and tetraboric acid are preferable. Furthermore, examples of the boric acid salt include an alkali metal salt and an alkaline earth metal salt; an orthoboric acid salt, a diboric acid salt, a metaboric acid salt, a tetraboric acid salt, a pentaboric acid salt, and an octaboric acid salt can be cited, and among them an orthoboric acid salt and a tetraboric acid salt, in particular an alkali metal tetraboric acid salt, are preferable. Preferred examples of the tetraboric acid salt include sodium tetraborate, potassium tetraborate, and lithium tetraborate, and among them sodium tetraborate is preferable. Two or more types of boric acid salts may be used in combination. As the boric acid or boric acid salt that can be used in the present invention, orthoboric acid, tetraboric acid, or sodium tetraborate is particularly preferable. The developer may use boric acid and a boric acid salt in combination.

The ion of the water-soluble amine compound (c) can be generated in an aqueous solution of the water-soluble amine compound, an alkali or an acid may further be added to the aqueous solution of the water-soluble amine compound, or it can be made present in an aqueous solution by adding a compound that is a salt of the amine compound itself. The water-soluble amine compound is not particularly limited, but is preferably a water-soluble amine compound having a group that promotes water-solubility. Examples of the group that promotes water-solubility include a carboxylic acid group, a sulfonic acid group, a sulfinic acid group, a phosphonic acid group, and a hydroxy group. The water-soluble amine compound may contain a plurality of these groups in combination.

When the water-solubility of an amine compound is promoted by a carboxylic acid group, a sulfonic acid group, a sulfinic acid group, or a phosphonic acid group, it corresponds to an amino acid. An amino acid is in equilibrium in an aqueous solution, and when the acid group is for example a carboxylic acid group, the equilibrium can be expressed as shown below. The amino acid referred to in the present invention means state B below, and the ion of an amino acid referred to means state C. As a counterion in state C, sodium ion or potassium ion is preferable.

### Equilibrium of amino acid (when acid group is carboxylic acid)

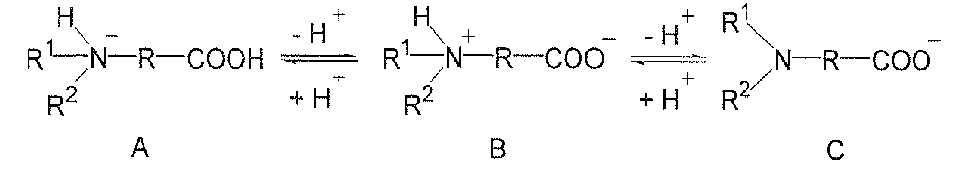

(For example, R¹ and R² independently denote a hydrogen atom, an alkyl group, an aryl group, etc., and R denotes a linking group.)

Specific examples of the water-soluble amine compound having a carboxylic acid group, a sulfonic acid group, or a sulfinic acid group include amino acids such as glycine, iminodiacetic acid, lysine, threonine, serine, aspartic acid, parahydroxyphenylglycine, dihydroxyethylglycine, alanine, anthranilic acid, and tryptophan, sulfamic acid, fatty acid aminesulfonic acids such as cyclohexylsulfamic acid and taurine, and fatty acid aminesulfinic acids such as aminoethanesulfinic acid. Among them, glycine and iminodiacetic acid are preferable.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid, and ethylenediaminopentamethylenephosphonic acid. 2-aminoethylphosphonic acid is particularly preferable.

The water-soluble amine compound having a hydroxy group as the group promoting water-solubility means an alkylamine having a hydroxy group on the alkyl group (state B' below), and an ion thereof means an ammonium ion of the amino group (state A' below). 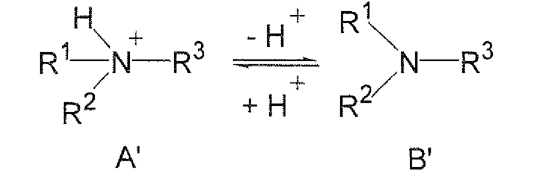 (For example, R¹, R², and R³ independently denote a hydrogen atom, an alkyl group, an aryl group, etc. At least one of R¹, R², and R³ is an alkyl group having a hydroxy group.)

Specific examples of the water-soluble amine compound having a hydroxy group include monoethanolamine, diethanolamine, trimethanolamine, triethanolamine, tripropanolamine, and triisopropanolamine. Among them, triethanolamine and diethanolamine are preferable. As the ammonium ion counterion, chloride ion is preferable.

Examples of an alkali that can be used for adjustment of pH include sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, an organic alkali agent, and a combination thereof. Furthermore, as an acid an inorganic acid such as, for example, hydrochloric acid, sulfuric acid, or nitric acid may be used. Adding such an alkali or acid enables the pH to be finely adjusted.

The pH of the developer used in the present invention is preferably in the range of 8.5 to 10.8, and when the pH is at least 8.5 the developability of a non-image area can be improved, whereas when it is no greater than 10.8 the influence of carbon dioxide in the air can be reduced and degradation of processing capacity due to the influence of carbon dioxide can be suppressed. The pH is more preferably in the range of 8.8 to 10.2, and particularly preferably in the range of 9.0 to 10.0.

When as the pH buffer agent the combination (a) carbonate ion and hydrogen carbonate ion is used, the total amount of carbonate ion and hydrogen carbonate ion is preferably 0.05 to 5 mol/L relative to the total amount of developer, more preferably 0.1 to 2 mol/L, and particularly preferably 0.2 to 1 mol/L. When the total amount is at least 0.05 mol/L the developability and processing capacity do not deteriorate, and when it is no greater than 5 mol/L there is hardly any formation of a precipitate or crystals, there is hardly any gelling when carrying out neutralization during waste solution treatment for the developer, and waste solution treatment can be carried out without problems.

Furthermore, for the purpose of finely adjusting the alkali concentration or assisting dissolution of a non-image area of the photosensitive layer, an alkali agent, for example, an organic alkali agent, may be added supplementarily. Examples of the organic alkali agent include monomethylamine, dimethylamine, trimethylamine, monoethylamine, diethylamine, triethylamine, monoisopropylamine, diisopropylamine, triisopropylamine, *n*-butylamine, monoethanolamine, diethanolamine, triethanolamine, monoisopropanolamine, diisopropanolamine, ethyleneimine, ethylenediamine, pyridine, and tetramethylammonium hydroxide. These alkali agents may be used singly or in a combination of two or more types.

When (b) borate ion is used as the pH buffer agent, the total amount of borate ion is preferably 0.05 to 5 mol/L relative to the total amount of developer, more preferably 0.1 to 2 mol/L, and particularly preferably 0.2 to 1 mol/L. When the total amount of boric acid salt is at least 0.05 mol/L, the developability and processing capacity do not deteriorate, and when it is no greater than 5 mol/L there is hardly any formation of a precipitate or crystals, there is hardly any gelling when carrying out neutralization during waste solution processing for the developer, and waste solution processing can be carried out without problems.

When (c) the water-soluble amine compound and an ion of the amine compound are used as the pH buffer agent, the total amount of the water-soluble amine compound and the ion of the amine compound is preferably 0.01 to 1 mol/L relative to the total amount of aqueous solution; when the total amount of the water-soluble amine compound and the ion of the amine compound is in this range the developability and processing capacity do not deteriorate, and the waste solution processing is easy. It is more preferably in the range of 0.03 to 0.7 mol/L, and particularly preferably in the range of 0.05 to 0.5 mol/L,

The developer used in the present invention may contain, in addition to the above-mentioned components, a wetting agent, a preservative, a chelating compound, an antifoaming agent, an organic solvent, an organic acid, an inorganic acid, an inorganic acid salt, a water-soluble resin, etc.

As the wetting agent, ethylene glycol, propylene glycol, triethylene glycol, butylene glycol, hexylene glycol, diethylene glycol, dipropylene glycol, glycerol, trimethylolpropane, diglycerol, etc. are suitably used. The wetting agent may be used singly or in a combination of two or more types. The wetting agent is generally used in an amount of 0.1 to 5 wt % relative to the total weight of the developer.

As the preservetive, for example, phenol or a derivative thereof, formalin, an imidazole derivative, sodium dehydroacetate, a 4-isothiazolin-3-one derivative, benzisothiazolin-3-one, 2-methyl-4-isothiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative, or a nitrobromoalcohol such as 2-bromo-2-nitropropane-1,3-diol, 1,1-dibromo-1-nitro-2-ethanol, or 1,1-dibromo-1-nitro-2-propanol is preferably used.

It is preferable to use in combination at least two types of preservatives so as to exhibit efficacy toward various types of molds and bacteria. The amount of preservative added is an amount that exhibits stable efficacy toward bacteria, molds, yeasts, etc., and depends on the type of bacteria, molds, or yeasts, but is preferably in the range of 0.01 to 4 wt % relative to the developer.

As the chelating compound, for example, ethylenediaminetetraacetic acid, the potassium salt thereof, or the sodium salt thereof; diethylenetriaminepentaacetic acid, the potassium salt thereof, or the sodium salt thereof; triethylenetetraminehexaacetic acid, the potassium salt thereof, or the sodium salt thereof; hydroxyethylethylenediaminetriacetic acid, the potassium salt thereof, or the sodium salt thereof; nitrilotriacetic acid or the sodium salt thereof; an organic phosphonic acid, for example, 1-hydroxyethane-1,1-diphosphonic acid, the potassium salt thereof, or the sodium salt thereof; or aminotri(methylenephosphonic acid), the potassium salt thereof, or the sodium salt thereof; or a phosphonoalkanetricarboxylic acid can be cited. An organic amine salt is also effective instead of the sodium salt or potassium salt of the chelating compounds. Two or more types of chelating compounds may be used in combination.

As the chelating compound, one that is present stably in the processing liquid composition and does not inhibit printing properties is selected. The amount thereof added is suitably 0.001 to 1.0 wt % relative to the developer.

As the antifoaming agent, a silicon antifoaming agent is preferable, and a normal silicon-based self emulsifying type, emulsifying type, nonionic, etc. compound having an HLB of no greater than 5 may be used. Among them, an emulsifying dispersion type and solubilizing type are preferably used. The content of the antifoaming agent is suitably in the range of 0.001 to 1.0 wt % relative to the developer.

Examples of the organic solvent that can be contained in the developer include an aliphatic hydrocarbon (e.g. hexane, heptane, Isopar E, Isopar H, Isopar G (Esso Chemical Co., Ltd.), gasoline or kerosene), an aromatic hydrocarbon (e.g. toluene or xylene), a halogenated hydrocarbon (methylene dichloride, ethylene dichloride, triclene, or monochlorobenzene), and a polar solvent.

Examples of the polar solvent include an alcohol (e.g. methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenylcarbinol, *n*-amyl alcohol, or methylamyl alcohol), a ketone (e.g. acetone, methyl ethyl ketone, ethyl butyl ketone, methyl isobutyl ketone, or cyclohexanone), an ester (e.g. ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, or butyl levulinate), and others (e.g. triethyl phosphate, tricresyl phosphate, *N*-phenylethanolamine, or *N*-phenyldiethanolamine).

Furthermore, when the organic solvent is insoluble in water, it may be employed by being solubilized in water using a surfactant or the like. In the case where the developer contains an organic solvent, the concentration of the organic solvent is preferably less than 40 wt % from the viewpoint of safety and inflammability.

As the organic acid, for example, citric acid, acetic acid, oxalic acid, malonic acid, salicylic acid, caprylic acid, tartaric acid, malic acid, lactic acid, levulinic acid, *p*-toluenesulfonic acid, polystylenesulfonic acid, xylenesulfonic acid, phytic acid, and an organic phosphonic acid can be cited. The organic acid may also be used in the form of an alkali metal salt or an ammonium salt.

As the inorganic acid and an inorganic acid salt, for example, phosphoric acid, metaphosphoric acid, monoammonium phosphate, diammonium phosphate, monosodium phosphate, disodium phosphate, monopotassium phosphate, dipotassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, and nickel sulfate can be cited. The organic acid and/or the inorganic acid may be used in a combination of two or more types. The total content of the organic acid and the inorganic acid in the developer is preferably 0.01 to 0.5 wt %, and more preferably 0.05 to 10 wt %.

The water-soluble polymer compound that can be used in the developer of the present invention includes, for example, soybean polysaccharide, modified starch, gum Arabic, dextrin, a cellulose derivative (for example, carboxymethylcellulose, carboxyethylcellulose or methylcellulose) or a modified product thereof, pullulan, polyvinyl alcohol or a derivative thereof, polyvinylpyrrolidone, polyacrylamide, an acrylamide copolymer, a vinyl methyl ether/maleic anhydride copolymer, a vinyl acetate/maleic anhydride copolymer, and a styrene/maleic anhydride copolymer. The water-soluble resin preferably has an acid value of 0 to 3.0 meq/g.

As the soybean polysaccharide, known ones can be used. For example, as a commercial product, Soyafibe (trade name, Fuji Oil Co., Ltd.) is available, and various product grades can be used. The soybean polysaccharide preferably used has a viscosity in the range of 10 to 100 mPa·sec in a 10 wt % aqueous solution thereof.

As the modified starch, for example, there is a modified starch represented by Formula (III). As the modified starch of Formula (III), any starches of corn, potato, tapioca, rice, or wheat can be used. The modified starches can be prepared by a method wherein starch is decomposed with an acid or an enzyme to the extent that the number of glucose residues per molecule is from 5 to 30 and then oxypropylene is added thereto in an alkali.

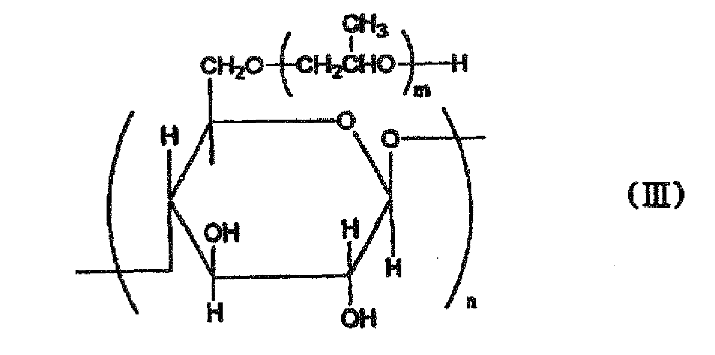

In Formula (III), the degree of efiherifiication (degree of substitution) is in the range of 0.05 to 1.2 per glucose unit, n denotes an integer of 3 to 30, and m denotes an integer of 1 to 3.

Examples of modified starch and derivatives thereof include roasted starch such as British gum, enzymatically-modified dextrin such as enzyme dextrin and Shardinger dextrin, oxidized starch such as solubilized starch, pregelatinized starch such as modified pregelatinized starch and unmodified pregelatinized starch, esterified starch such as starch phosphate, fatty starch, starch sulfate, starch nitrate, starch xanthate, and starch carbamate, etherified starch such as carboxyalkyl starch, hydroxyalkyl starch, sulfoalkyl starch, cyanoethyl starch, allyl starch, benzyl starch, carbamylethyl starch, and dialkylamino starch, crosslinked starch such as methylol-crosslinked starch, hydroxyalkyl-crosslinked starch, phosphoric acid-crosslinked starch, and dicarboxylic acid-crosslinked starch, and starch graft polymers such as starch polyacrylamide copolymer, starch polyacrylic acid copolymer, starch polyvinyl acetate copolymer, starch polyacrylonitrile copolymer, cationic starch polyacrylic acid ester copolymer, cationic starch vinyl polymer copolymer, starch polystyrene maleic acid copolymer, starch polyethylene oxide copolymer, and starch polypropylene copolymer.

Among the water-soluble resins, soybean polysaccharide, modified starch, gum Arabic, dextrin, carboxymethylcellulose, polyvinyl alcohol, etc. are preferable. The water-soluble resin may be used in a combination of two or more types. The content of the water-soluble resin in the processing liquid is preferably 0.1 to 20 wt %, and more preferably 0.5 to 10 wt %.

In development processing using an automatic processor, since the processing performance of the developer might degrade depending on the amount processed, the processing performance may be recovered by use of a replenisher or fresh developer.

After the development step is carried out, the developer may be dried by natural drying, but it is preferable to provide a drying step employing hot air, etc.

In the present invention, it is preferable to include, subsequent to the exposure step and prior to the development processing step, a step of heating the lithographic printing plate precursor to 100°C or higher. In the process for producing a lithographic printing plate of the present invention, the entire surface may be heated from exposure to development as necessary. By heating in this way, an image-forming reaction in the image recording layer is accelerated and advantages in terms of, for example, improvement in sensitivity and plate life and stabilization of sensitivity are achieved. Heating conditions may be appropriately set within a range that exhibits these effects. As heating means, a commonly used convection oven, IR irradiator, IR laser, microwave device, Wisconsin oven, etc. can be cited.

The heating step may be carried out by holding the plate at a surface temperature of 100°C to 150°C for 1 sec to 5 min, preferably at 100°C to 140°C for 5 sec to 1 min, and more preferably at 100°C to 130°C for 10 to 30 sec. It is preferable for the conditions to be in these ranges since the above-mentioned effects can be obtained efficiently and adverse effects such as deformation of the lithographic printing plate due to heat can be prevented.

Heating means used in the heating treatment is preferably connected to a plate setter used in the exposure step and a developing machine used in the development processing step, thus carrying out automatic continuous processing. Specific examples thereof include a plate making line in which a plate setter and a developing machine are connected via transport means such as a conveyor. The heating means may be placed between the plate setter and the developing machine, or the heating means and the developing machine may be integrated.

When a lithographic printing plate precursor used is susceptible to ambient light in the operating environment, the above-mentioned plate making line is preferably shielded from light by a filter or a cover.

The lithographic printing plate after development may be subjected to overall exposure using actinic radiation such as UV rays so as to promote curing of an image area. Examples of a light source used for overall exposure include a carbon arc lamp, a mercury lamp, a gallium lamp, a metal halide lamp, a xenon lamp, a tungsten lamp, and various types of laser light. In order to obtain sufficient plate life, the exposure is preferably at least 10 mJ/cm², and more preferably at least 100 mJ/cm².

Heating may be carried out at the same time as overall exposure, and it is observed that plate life is further improved by heating. As a heating device, a commonly used convection oven, IR irradiator, IR laser, microwave device, Wisconsin oven, etc. can be cited. In this process, the plate surface temperature is preferably 30°C to 150°C, more preferably 35°C to 130°C, and yet more preferably 40°C to 120°C. Specifically, a method described in JP-A-2000-89478 may be utilized.

Furthermore, for the purpose of improving plate life, etc., the printing plate after development may be heated under very severe conditions. The heating temperature is preferably in the range of 200°C to 500°C. When in the above-mentioned range, a sufficient image strengthening effect is obtained, and there are no problems such as degradation of a support or thermal decomposition of an image area. The lithographic printing plate thus obtained is set in an offset printer, and used for printing of a large number of sheets.

### Examples

The present invention is explained below by way of Examples, but the present invention should not be construed as being limited thereto. In addition, 'parts' described below means 'parts by weight' unless otherwise specified, and '%' described below means 'wt %' unless otherwise specified.

### Examples 1 to 17 and Comparative examples 1 to 4

### Preparation of Support 1

A 0.3 mm thick aluminum plate (material: 1050) was subjected to a degreasing treatment with a 10 wt % aqueous solution of sodium aluminate at 50°C for 30 sec in order to remove rolling oil on the surface thereof. Thereafter, the aluminum plate surface was grained using three nylon brushes implanted with bundled bristles having a diameter of 0.3 mm and an aqueous suspension (specific gravity: 1.1 g/cm³) of pumice having a median diameter of 25 µm and then washed well with water. The plate was etched by immersing it in a 25 wt % aqueous solution of sodium hydroxide at 45°C for 9 sec and, after washing with water, was immersed in 20 wt % nitric acid at 60°C for 20 sec, followed by washing with water. The amount of etching of the grained surface was about 3 g/m².

Subsequently, the aluminum plate was subjected to a consecutive electrochemical surface roughening treatment using an AC voltage of 60 Hz. An electrolytic liquid used here was a 1 wt % aqueous solution of nitric acid (containing 0.5 wt % of aluminum ion) at a liquid temperature of 50°C. The electrochemical surface roughening treatment was carried out using as an AC power source waveform a trapezoidal rectangular wave alternating current having a duty ratio of 1:1 and a time TP from zero to peak current value of 0.8 msec, with a carbon electrode as the counter electrode. Ferrite was used as an auxiliary anode. The current density was 30 A/dm² as a peak current value, and 5% of the current flowing from the power source was diverted to the auxiliary anode. The quantity of electricity in the nitric acid electrolysis was 175 C/dm² when the aluminum plate was the anode. Following this, washing with water was carried out by means of a spray.

Subsequently, the aluminum plate was subjected to an electrochemical surface roughening treatment in the same manner as in the nitric acid electrolysis above using, as an electrolytic liquid, a 0.5 wt % aqueous solution of hydrochloric acid (containing 0.5 wt % of aluminum ion) at a liquid temperature of 50°C under conditions of a quantity of electricity of 50 C/dm² when the aluminum plate was the anode, and was then washed with water by spraying. The plate was then treated in 15 wt % sulfuric acid (containing 0.5 wt % of aluminum ion) as an electrolytic liquid at a current density of 15 A/dm² to provide a direct current anodic oxide film of 2.5 g/m², was then washed with water, and dried. The center line average roughness (Ra) of the thus obtained support was measured using a stylus having a diameter of 2 µm and found to be 0.51 µm.

Furthermore, undercoat liquid (1) below was applied using a bar to give a dry coat weight of 10 mg/m² and dried in an oven at 80°C for 10 sec to prepare a support having an undercoat layer to be used below.

### Undercoat Liquid (1)

| | |
|---|---|
| Undercoat compound (1) below (molecular weight: 100,000) | 0.017 parts |
| 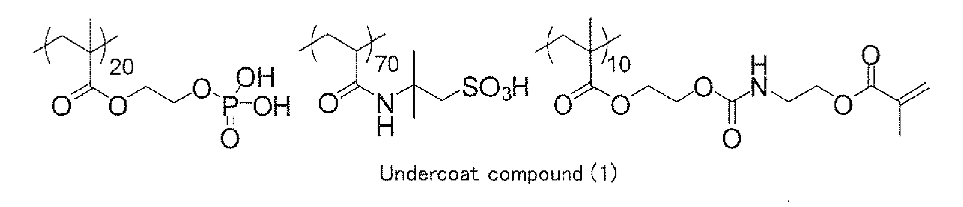 | |
| Methanol | 9.00 parts |
| Water | 1.00 parts |

### Preparation of Lithographic Printing Plate Precursor (1) to (21)

The support having the undercoat layer applied thereto was coated with a photosensitive layer coating liquid (1) having the composition below using a bar and dried in an oven at 70°C for 60 sec to form a photosensitive layer having a dry coat weight of 1.1 g/m². Onto the photosensitive layer, protective layer coating liquid (1) having the composition below was applied using a bar so as to give a dry coat weight of 0.75 g/m² and dried at 125°C for 70 sec to prepare lithographic printing plate precursor (1). Lithographic printing plate precursors (2) to (21) were prepared in the same manner as for lithographic printing plate precursor (1) except that compound C-01 was changed to a compound shown in Table 2.

### Photosensitive Layer Coatinq Liquid 1

| | |
|---|---|
| Binder polymer (1) below (average molecular weight: 80,000, acid value: 0 meq/g) | 0.54 parts |
| 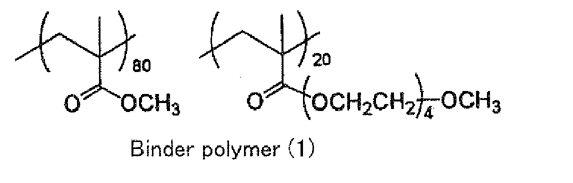 | |
| Polymerizable compound (EO-modified isocyanurate triacrylate (Aronix M-315, Toa Gosei Co., Ltd.)) | 0.40 parts |
| Polymerizable compound (Ethoxylated trimethylolpropane triacrylate, SR9035, | |
| number of moles of EO added: 15, molecular weight: 1,000, SARTOMER) | 0.08 parts |
| Sensitizing dye (1) below | 0.06 parts |
| 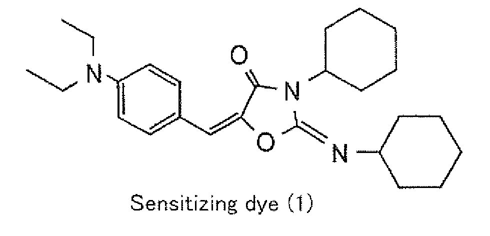 | |
| Polymerization initiator (1) below | 0.18 parts |
| 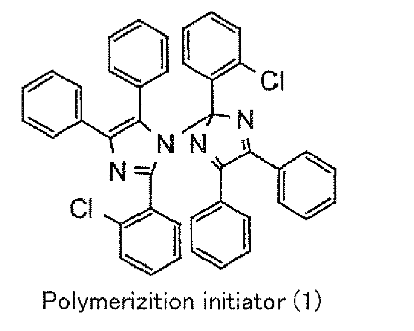 | |
| Chain transfer agent (1) below | 0.07 parts |
| 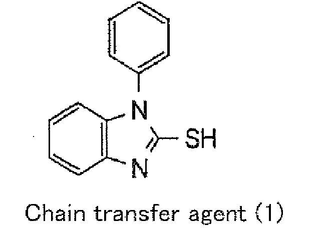 | |
| ε-Phthalocyanine pigment dispersion (1) | 0.40 parts |
| [pigment: 15 parts, allyl methacrylatelmethacryiic acid (80/20) copolymer (molecular weight: 70,000): 10 parts as dispersant, cyclohexanone/methoxypropyl acetate /1-methoxy-2- propanol = 15 parts /20 parts /40 parts as solvent] Thermal polymerization inhibitor (*N*-Nitrosophenylhydroxylamine aluminum salt) | 0.01 parts |
| Fluorine-based surfactant (1) (Molecular weight: 11,000) below | 0.001 parts |
| 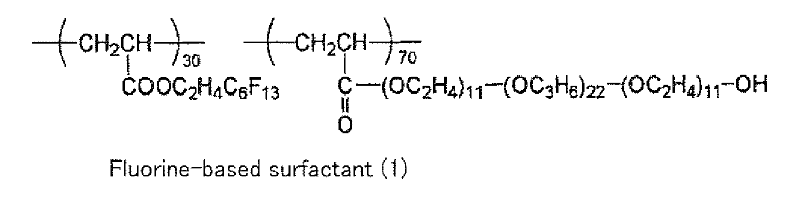 | |
| Polyoxyethylene-polyoxypropylene condensate (Pluronic L44, ADEKA Corp.) | 0.04 parts |
| 1-Mefhoxy-2-propanol | 3.5 parts |
| Methyl ethyl ketone | 8.0 parts |
| Compoud shown in Table 2 | 0.1 parts |

### Protective Layer Coating Liquid (1)

| | |
|---|---|
| Polyvinyl alcohol (degree of saponification: 98 mol %; degree of polymerization: 500) | 40 parts |
| Polyvinylpyrrolidone (molecular weight: 50,000) | 5 parts |
| Poly(vinylpyrrolidone/vinyl acetate (1/1)) (molecular weight: 70,000) | 0.5 parts |
| Surfactant (polyoxyethylene lauryl ether, Emalex 710, Nihon-Emulsion Co., Ltd.) | 0.5 parts |
| Water | 950 parts |

### Exposure and development conditions

### (1) Standard lithographic printing plate making conditions

Each of the lithographic printing plate precursors (1) to (21) thus obtained was imagewise exposed using a Violet semiconductor laser plate setter Vx9600 (equipped with an InGaN semiconductor laser, emission: 405 nm ± 10 nm/output: 30 mW, FUJIFILM Electronic Imaging, Ltd.). For the image, a 50% screen tint was drawn using an FM screen (TAFFETA 20, Fuji Photo Film Co., Ltd.) with a plate surface exposure of 0.05 mJ/cm² at a resolution of 2,438 dpi.

Subsequently, development processing was carried out in an automatic development processor having the structure shown in FIG. 1 using developer (1) having the composition below. The automatic development processor was an automatic processor having two rotating brush rollers. As the rotating brush rollers used, the first brush roller was a brush roller having an outer diameter of 90 mm and having implanted therein fibers of polybutylene terephthalate (bristle diameter: 200 µm, bristle length: 17 mm), and the brush roller was rotated at 200 rpm in the same direction as the transport direction (peripheral speed at brush tip: 0.94 m/sec). The second brush roller was a brush roller having an outer diameter of 60 mm having implanted therein fibers of polybutylene terephthalate (bristle diameter: 200 µm, bristle length: 17 mm), and the brush roller was rotated at 200 rpm in the opposite direction to the transport direction (peripheral speed at brush tip: 0.63 m/sec). Transport of the lithographic printing plate precursor was carried out at a transport speed of 95 cm/min.

The developer was supplied onto the surface of the lithographic printing plate precursor by showering from a spray pipe using a circulation pump. The tank volume for the developer was 10 liters. Standard lithographic printing plates (1) to (21) were thus prepared.

### (2) Conditions for making post-heated lithographic printing plate

Each of the lithographic printing plate precursors (1) to (21) thus obtained was imagewise exposed using a Violet semiconductor laser plate setter Vx9600 (equipped with an InGaN semiconductor laser, emission: 405 nm ± 10 nm/output: 30 mW, FUJIFILM Electronic Imaging, Ltd.). For the image, a 50% screen tint was exposed imagewise using an FM screen (TAFFETA 20, Fuji Photo Film Co., Ltd.) with a plate surface exposure of 0.05 mJ/cm² at a resolution of 2,438 dpi, and the lithographic printing plate precursor was then placed in an oven within 30 sec after exposure, the entire surface of the lithographic printing plate precursor was heated by blowing hot air, and it was held at 110°C for 15 sec. Within 30 sec thereafter, development processing was carried out in the same manner as for standard lithographic printing plate making, thereby making post-heated lithographic printing plates (1) to (21).

### (3) Conditions for making lithographic printing plates for evaluation of sensitivity

Each of the lithographic printing plate precursors (1) to (21) was imagewise exposed at various exposures using a 405 nm semiconductor laser with an output of 100 mW. Subsequently, development was carried out with the same conditions as those for making the standard lithographic printing plates, thus giving lithographic printing plates (1) to (21) for evaluation of sensitivity.

### (4) Conditions for making lithographic printing plates for evaluation of developability

Each of the lithographic printing plate precursors (1) to (21) was imagewise exposed with the same conditions as those for making the standard lithographic printing plates, and development processing was carried out with the same conditions as those for making the standard lithographic printing plates except that the transport speed of the lithographic printing plate precursor was variously changed, thus giving lithographic printing plates (1) to (21) for evaluation of developability.

### Developer (1)

| | |
|---|---|
| Water | 100.00 parts |
| Benzyl alcohol | 1.00 part |
| Polyoxyethylene naphthyl ether (average number of oxyethylenes n 13) | = 1.00 part |
| Sodium dioctylsulfosuccinate | 0.50 parts |
| Gum Arabic (Mw = 200,000) | 1.00 part |
| Ethylene glycol | 0.50 parts |
| Ammonium phosphate, monobasic | 0.05 parts |
| Citric acid | 0.05 parts |
| Tetrasodium ethylenediamine tetraacetate | 0.05 parts |

The pH of the developer was adjusted to 7.0 using phosphoric acid and sodium hydroxide.

### Printing conditions

The lithographic printing plate after development was mounted on a SOR-M printing machine (Heidelberg), and printing was carried out at a printing speed of 6,000 sheets per hour using dampening water (EU-3 (etching liquid, Fujifilm Co., Ltd.))/water/isopropyl alcohol = 1/89/10 (ratio by volume)) and TRANS-G(N) black ink (Dai-Nippon Ink & Chemicals, Inc.).

### (5) Evaluation

Sensitivity, developability, Staining properties, and plate life were evaluated as follows using the lithographic printing plate precursors and lithographic printing plates prepared above. The results are given in Table 2. Sensitivity

Lithographic printing plates (1) to (21) for evaluation of sensitivity were exposed at various exposures, development and printing (100 sheets) were carried out as described above, and after confirming that a printed material free from ink staining in a non-image area was obtained, 500 sheets were subsequently printed. The 600th sheet of the total printed material was used, and the exposure (µJ/cm²) that gave uniform ink density in an image area was determined and defined as the sensitivity.

### Developability

Lithographic printing plates (1) to (21) for evaluation of developability were subjected to measurement of cyan density of a non-image area using a Macbeth densitometer. The transport speed (cm/min) at which the cyan density of a non-image area became the same as the cyan density of an aluminum substrate was determined and defined as the developability.

### Staining properties

500 sheets were printed as described above using standard lithographic printing plates and post-heated lithographic printing plates, and ink staining occurring in a non-image area was examined using an X-Rite densitometer. The 500th sheet printed was evaluated as being 10 points when a non-image area was obtained without any staining at all, and 0 points when ink became attached to and stained almost all the area. An evaluation of 10 points was defined as a pass.

**(Table 1)**

| Points | 0 | 1 | 2 | 3 | 4 | 5 | 6 | 7 | 8 | 9 | 10 |
|---|---|---|---|---|---|---|---|---|---|---|---|
| Density of non-image area | 1.551 | 1.194 | 0.871 | 0.583 | 0.540 | 0.299 | 0.144 | 0.116 | 0.091 | 0.083 | 0.081 |

### Plate life

Printing was carried out as described above using standard lithographic printing plates and post-heated lithographic printing plates, and the plate life was evaluated using the number of sheets printed before the ink density (reflection density) on the printed paper decreased by 0.1 from that when printing started.

**(Table 2)**

| Ex. Comp. Ex. | Lithographic printing plate precursor | | | | Result of evaluation | | | | | |
|---|---|---|---|---|---|---|---|---|---|---|
| | No. | Compound | | | Sensitivity (µJ/cm²) | Developability (cm/min) | Staining properties | | Plate life | |
| | | No. | Dipole moment (debye) | Log P | | | Standard (point) | Post-heated (point) | Standard (× 10⁴ sheets) | Post-heated ( × 10⁴ sheets) |
| Ex, 1 | (1) | G-01 | 4.72 | -1.55 | 230 | 130 | 10 | 10 | 5.5 | 6.5 |
| Ex. 2 | (2) | C-02 | 11.15 | -2.23 | 150 | 150 | 10 | 10 | 9.0 | 10.0 |
| Ex. 3 | (3) | C-03 | 7.31 | -0.31 | 180 | 110 | 10 | 10 | 8.0 | 9.0 |
| Ex. 4 | (4) | C-07 | 4.06 | -2.24 | 240 | 150 | 10 | 10 | 5.5 | 6.5 |
| Ex. 5 | (5) | C-11 | 5.19 | 0.04 | 200 | 105 | 10 | 10 | 6.0 | 7.0 |
| Ex. 6 | (6) | C-15 | 8.84 | -2.04 | 150 | 150 | 10 | 10 | 9.0 | 10.0 |
| Ex. 7 | (7) | G-16 | 7.01 | -0.04 | 170 | 105 | 10 | 10 | 8.0 | 9.0 |
| Ex. 8 | (8) | C-18 | 6.96 | 0.65 | 190 | 100 | 10 | 10 | 8.0 | 9.0 |
| Ex. 9 | (9) | C-21 | 8.68 | -1.05 | 150 | 130 | 10 | 10 | 9.0 | 10.0 |
| Ex. 10 | (10) | C-24 | 6.43 | -0.60 | 190 | 110 | 10 | 10 | 6.5 | 7.5 |
| Ex. 11 | (11) | C-25 | 5.45 | -0.35 | 200 | 110 | 10 | 10 | 6.0 | 7.0 |
| Ex. 12 | (12) | C-26 | 6.08 | 0.45 | 190 | 105 | 10 | 10 | 6.5 | 7.5 |
| Ex. 13 | (13) | C-27 | 5.69 | 0.86 | 200 | 100 | 10 | 10 | 6.0 | 7.0 |
| Ex, 14 | (14) | C-30 | 4.60 | 0.59 | 230 | 105 | 10 | 10 | 5.5 | 6.5 |
| Ex. 15 | (15) | C-31 | 5,12 | 0.45 | 200 | 105 | 10 | 10 | 6.0 | 7.0 |
| Ex. 16 | (16) | C-36 | 5.44 | 0.80 | 200 | 100 | 10 | 10 | 6.0 | 7.0 |
| Ex.17 | (17) | C-41 | 4.53 | 0.87 | 230 | 100 | 10 | 10 | 5.5 | 6.5 |
| Comp. Ex. 1 | (18) | - | 0.00 | 0.00 | 300 | 80 | 9 | 9 | 4.0 | 5.0 |
| Comp. Ex. 2 | (19) | R-02 | 5.15 | 1.78 | 200 | 70 | 8 | 8 | 6.0 | 7.0 |
| Comp. Ex. 3 | (20) | R-03 | 0.97 | -1.76 | 300 | 130 | 10 | 10 | 4.0 | 5.0 |
| Comp. Ex. 4 | (21) | R-14 | 1.20 | 1.94 | 300 | 70 | 8 | 8 | 4.0 | 5.0 |

In Table 2, R-02, R-03, and R-14 denote the compounds below.

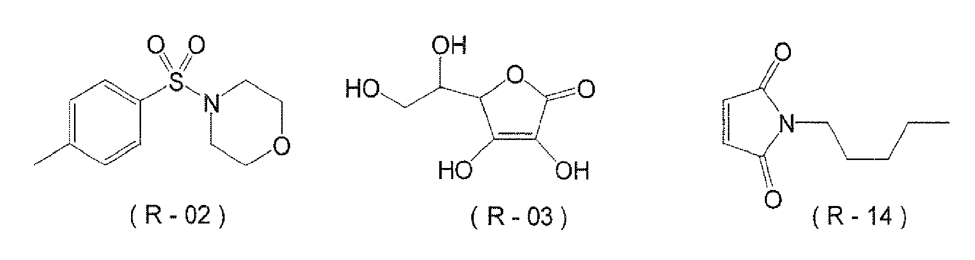

### Examples 18 to 20 and Comparative example 5

### Preparetion of Lithographic printing plate precursors (22) to (25)

Lithographic printing plate precursors (22) to (25) were prepared in the same manner as for lithographic printing plate precursor (1) except that the photosensitive layer coating liquid (1) was changed to a photosensitive layer coating liquid (2) below.

### Photosensitive layer coating liquid (2)

| | |
|---|---|
| Binder polymer (2) (P-28, average molecular weight: 70,000) below | 0.54 parts |
| 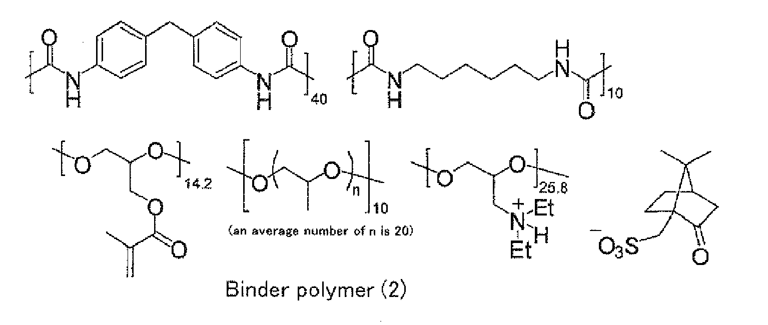 | |
| Polymerising compound (2) below | 0.48 parts |
| 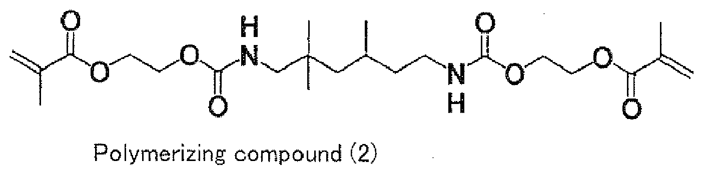 | |
| Sensitizing dye (1) above | 0.06 parts |
| Polymerization initiator (1) above | 0.18 parts |
| Chain transfer agent (1) above | 0.07 parts |
| ε-Phthalocyanine pigment dispersion (1) | 0.40 parts |
| [pigment: 15 parts, allyl methacrylate/methacrylic acid (80/20) copolymer (molecular weight: 70,000): 10 parts as dispersant, cyclohexanone/methoxypropyl acetate /1-methoxy-2- propanol = 15 parts /20 parts /40 parts as solvent] Thermal polymerization inhibitor (*N*-Nitrosophenylhydroxylamine aluminum salt) | 0.01 parts |
| Fluorine-based surfactant (1)(molecular weight: 11,000) above | 0.001 parts |
| Polyoxyethylene-polyoxypropylene condensate (Pluronic L44, ADEKA Corp.) | 0.04 parts |
| 1-Methoxy-2-propanol | 3.5 parts |
| Methyl ethyl ketone | 8.0 parts |
| Compoud shown in Table 3 | 0.05 parts |

Lithographic printing plate precursors (22) to (25) thus obtained were imagewise exposed using a Violet semiconductor laser plate setter Vx9600 (equipped with an inGaN semiconductor laser, emission: 405 nm ± 10 nm/output: 30 mW, FUJIFILM Electronic Imaging, Ltd.). For the image, a 50% screen tint was drawn using an FM screen (TAFFETA 20, Fuji Photo Film Co., Ltd.) with a plate surface exposure of 0.05 m/cm² at a revolution of 2,438 dpi. The lithographic printing plate precursor was placed in an oven within 30 sec after exposure, the entire surface of the lithographic printing plate precursor was heated by blowing hot air, and it was held at 110°C for 15 sec. Within 30 sec thereafter, development was carried out in the same manner as in Example 1 except that developer (1) was changed to developer (2) below. The results are given in Table 3.

### Developer (2)

| | |
|---|---|
| Water | 100.00 parts |
| *N*-Lauryldimethylbetaine (Pionin C157K, Takemoto Oil & Fat Co., Ltd.) | 10.00 parts |
| Polystyrenesulfonic acid (Mw = 50,000) | 1.00 part |
| Ammonium phosphate, monobasic | 0.05 parts |
| Citric acid | 0.05 parts |
| Tetrasodium ethylenediamine tetraacetate | 0.05 parts |

The pH of the developer was adjusted to 4.5 using phosphoric acid.

**(Table 3)**

| Ex. Comp. Ex. | Lithographic printing plate precursor | | | | Result of evaluation | | | | | |
|---|---|---|---|---|---|---|---|---|---|---|
| | No. | Compound | | | Sensitivity (µJ/cm²) | Developability (cm/min) | Staining properties | | Plate life | |
| | | No. | Dipole moment (debye) | Log P | | | Standard (print) | Post-heared (point) | Standard ( × 10⁴sheets) | Post heated ( × 10⁴sheets) |
| Ex. 18 | (22) | C-01 | 4.72 | -1.55 | 240 | 125 | 10 | 10 | 6.0 | 7.0 |
| Ex. 19 | (23) | C-02 | 11.15 | -2.23 | 160 | 150 | 10 | 10 | 10.0 | 11.0 |
| Ex. 20 | (24) | C-25 | 5.45 | -0.35 | 210 | 105 | 10 | 10 | 7.0 | 8.0 |
| Comp. Ex. 5 | (25) | - | 0.00 | 0.00 | 300 | 80 | 9 | 9 | 5.0 | 6.0 |

### Examples 21 to 23 and Comparative Example 6

### Preparation of lithographic printing plate precursors (26) to (29)

Lithographic printing plate precursors (26) to (29) were obtained in the same manner as in the preparation of lithographic printing plate precursor (1) except that photosensitive layer coating liquid (1) was changed to photosensitive layer coating liquid (3) having the composition below and protective layer coating liquid (1) was changed to protective layer coating liquid (2) having the composition below.

### Photosensitive layer coating liquid (3)

| | |
|---|---|
| Binder polymer (3) (P-28, average molecular weight: 50,000) below | 0.54 parts |
| 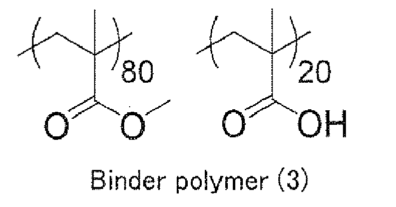 | |
| Polymerizable compound (2) above | 0.48 parts |
| Sensitizing dye (1) above | 0.06 parts |
| Polymerization Initiator (1) above | 0.18 parts |
| Chain transfer agent (1) above | 0.07 parts |
| ε-Phthalocyanine pigment dispersion (1) | 0.40 parts |
| [pigment: 15 parts by weight, allyl methacrylate/methacrylic acid (80/20) copolymer (molecular weight 70,000): 10 parts by weight as dispersant, cyclohexanone/methoxypropyl acetate /1-methoxy-2-propanol = 15 parts/20 parts/40 parts as solvent] Thermal polymerization inhibitor (*N*-Nitrosophenylhydroxylamine aluminum salt) | 0.01 parts |
| Fluorine-based surfactant (1) above | 0.001 parts |
| Polyoxyethylene-polyoxypropylene condensate (Pluronic L44, ADEKA Corp.) | 0.04 parts |
| 1-Methoxy-2-propanol | 3.5 parts |
| Methyl ethyl ketone | 8.0 parts |
| Compound shown in Table 4 | 0.08 parts |

### Protective laver coating liquid 2

| | |
|---|---|
| Mica dispersion (1) below | 13.0 parts |
| Polyvinyl alcohol (degree of saponification: 98 mol %; degree of Polymerization: 500) | 1.3 parts |
| Sodium 2-ethylhexylsuifosuccinate | 0.2 parts |
| Poly(vinylpyrrolidone/vinyl acetate (1/1)) (molecular weight: 70,000) | 0.05 parts |
| Surfactant (Emalex 710, Nihon-Emulsion Co., Ltd.) | 0.05 parts |
| Water | 133 parts |

### Preparation of Mica Dispersion (1)

32 parts of synthetic mica ('SOMASIF ME-100': CO-OP Chemical Co., Ltd.; aspect ratio: 1,000 or greater) was added to 368 parts of water and dispersed using a homogenizer until the average particle size (laser scattering method) became 0.5 µm, thus giving mica dispersion (1).

Lithographic printing plate precursors (26) to (29) thus obtained were evaluated in the same manner as in Example 1 except that developer (1) was changed to developer (3) described below. The results are given in Table 4.

### Developer (3)

| | |
|---|---|
| Water | 100.00 parts |
| Benzyl alcohol | 1.00 part |
| Polyoxyethylene naphthyl ether (average number of oxyethylenes n = 13) | 1.00 part |
| Sodium dioctylsulfosuccinate | 0.50 parts |
| Gum Arabic (molecular weight 200,000) | 1.00 part |
| Ethylene glycol | 0.50 parts |
| Ammonium phosphate, monobasic | 0.05 parts |
| Citric acid | 0.05 parts |
| Sodium carbonate | 1.40 parts |
| Sodium hydrogen carbonate | 0.59 parts |

The pH of the developer was adjusted to 9.8 using phosphoric acid and sodium hydroxide.

**(Table 4)**

| Ex. Comp. Ex. | Lithographic printing plate precursor | | | | Result of evaluation | | | | | |
|---|---|---|---|---|---|---|---|---|---|---|
| | No. | Compound | | | Sensitivity (µJ/cm²) | Developability (cm/min) | Staining properties | | Plate life | |
| | | No. | Dipole moment (debye) | Log P | | | Standard (point) | Post-heated (point) | Standard ( × 10⁴sheets) | Post-heated ( × 10⁴sheets) |
| Ex. 21 | (26) | C-07 | 4.06 | -2.24 | 240 | 150 | 10 | 10 | 6.0 | 7.0 |
| Ex. 22 | (27) | C-11 | 5.19 | 0.04 | 200 | 105 | 10 | 10 | 6.5 | 7.5 |
| Ex.23 | (28) | C-31 | 5.12 | 0.45 | 200 | 105 | 10 | 10 | 6.5 | 7.5 |
| Comp Ex. 6 | (29) | - | 0.00 | 0.00 | 300 | 80 | 9 | 9 | 4.5 | 5.5 |

### Examples 24 to 27 and Comparative example 7

### Preparetion of Lithographic printing plate precursors (30) to (34)

### Preparation of Aluminum Support 2

A 0.3 mm thick aluminum plate in accordance with JIS A1050 was processed by subjecting it in sequence to steps (a) to (k) below.

### (a) Mechanical roughening treatment

The surface of the aluminum plate was subjected to a mechanical roughening treatment by means of a rotating roll-shaped nylon brush while supplying a suspension of an abrasive (silica sand) having a specific gravity of 1.12 in water as an abrasive slurry to the surface of the aluminum plate. The abrasive had an average particle size of 8 µm and a maximum particle size of 50 µm. The material of the nylon brush was nylon 6,10, the bristle length was 50 mm, and the diameter of the bristles was 0.3 mm. The nylon brush was formed by making holes in a stainless steel tube having a diameter of 300 mm and densely implanting the bristles. Three rotating brushes were used. The distance of two support rollers (φ 200 mm) below the brush was 300 mm. The brush rollers were pressed against the aluminum plate so that the load on a drive motor for rotating the brushes increased by 7 kW from the load before pressing the brush rollers. The direction of rotation of the brushes was the same as the direction in which the aluminum plate moved. The rotational speed of the brushes was 200 rpm.

### (b) Alkali etching treatment

The aluminum plate thus obtained was subjected to an etching treatment by spraying an NaOH aqueous solution (concentration 26 wt %, aluminum ion concentration 6.5 wt %) at 70°C so as to dissolve 6 g/m² of the aluminum plate. Subsequently, washing with water was carried out by means of a spray using well water.

### (c) Desmutting treatment

A desmutting treatment was carried out by means of a spray using an aqueous solution having a nitric acid concentration of 1 wt % and a temperature of 30°C (containing 0.5 wt % of aluminum ion), and following this washing with water was carried out by means of a spray. The aqueous solution of nitric acid used in the desmutting treatment employed liquid waste from a step involving carrying out the electrochemical roughening treatment using alternating current in an aqueous solution of nitric acid.

### (d) Electrochemical roughening treatment

An electrochemical roughening treatment was carried out consecutively using an AC voltage of 60 Hz. The electrolytic liquid in this process was a 10.5 g/L aqueous solution of nitric acid (containing 5 g/L of aluminum ion), and the temperature was 50°C. The electrochemical roughening treatment was carried out using as an AC power source waveform a trapezoidal rectangular wave alternating current having a duty ratio of 1:1 and a time TP from zero to peak current value of 0.8 ms, with a carbon electrode as a counter electrode. Ferrite was used as an auxiliary anode. The electrolytic vessel used was of a radial cell type. The current density was 30 A/dm² as a peak current value, and the quantity of electricity was 220 C/dm² as the total quantity of electricity when the aluminum plate was the anode. 5% of the current flowing from the power source was diverted to the auxiliary anode. Subsequently, washing with water was carried out by means of a spray using well water.

### (e) Alkali etching treatment

The aluminum plate was subjected to an etching treatment at 32°C by means of a spray with a sodium hydroxide concentration of 26 wt % and an aluminum ion concentration of 6.5 wt % so as to dissolve 0.20 g/m² of the aluminum plate, remove a smut component containing aluminum hydroxide as a main component formed in the previous stage when carrying out the electrochemical roughening treatment using alternating current, and dissolve an edge portion of a pit formed to thus make the edge portion smooth. Subsequently, washing with water was carried out by means of a spray using well water. The amount etched was 3.5 g/m².

### (f) Desmutting treatment

A desmutting treatment was carried out by means of a spray using an aqueous solution having a nitric acid concentration of 15 wt % and a temperature of 30°C (containing 4.5 wt % of aluminum ion), and following this washing with water was carried out by means of a spray using well water. The aqueous solution of nitric acid used in the desmutting treatment employed liquid waste from the step involving carrying out the electrochemical roughening treatment using alternating current in an aqueous solution of nitric acid.

### (g) Electrochemical roughening treatment

An electrochemical roughening treatment was carried out consecutively using an AC voltage of 60 Hz. The electrolytic liquid in this process was a 7.5 g/L aqueous solution of hydrochloric acid (containing 5 g/L of aluminum ion), and the temperature was 35°C. The alternating current waveform of the power source was a rectangular wave, and the electrochemical roughening treatment was carried out using a carbon electrode as a counter electrode. Ferrite was used as an auxiliary anode. The electrolytic vessel was of a radial cell type. The current density was 25 A/dm² as a peak current value, and the quantity of electricity was 50 C/dm² as the total quantity of electricity when the aluminum plate was the anode. Following this, washing with water was carried out by means of a spray using well water.

### (h) Alkali etching treatment

The aluminum plate was subjected to an etching treatment at 32°C by means of a spray with a sodium hydroxide concentration of 26 wt % and an aluminum ion concentration of 6.5 wt % so as to dissolve 0.10 g/m² of the aluminum plate, remove a smut component containing aluminum hydroxide as a main component formed in the previous stage when carrying out the electrochemical roughening treatment using alternating current, and dissolve an edge portion of a pit formed to thus make the edge portion smooth. Subsequently, washing with water was carried out by means of a spray using well water.

### (i) Desmutting treatment

A desmutting treatment was carried out by means of a spray using an aqueous solution having a sulfuric acid concentration of 25 wt % and a temperature of 60°C (containing 0.5 wt % of aluminum ion), and following this washing with water was carried out by means of a spray using well water.

### (j) Anodizing treatment

As an electrolytic liquid, sulfuric acid was used. The electrolytic liquid had a sulfuric acid concentration of 170 g/L (containing 0.5 wt % of aluminum ion), and the temperature was 43°C. Subsequently, washing with water was carried out by means of a spray using well water. The current density was about 30 A/dm². The final amount of oxide film was 2.7 g/m².

### (k) Alkali metal silicate treatment

An aluminum plate thus obtained was immersed in a treatment bath with a 1 wt % aqueous solution of No. 3 sodium silicate at a temperature of 30°C for 10 sec, thus carrying out an alkali metal silicate treatment (silicate treatment). Subsequently, washing with water was carried out by means of a spray using well water, thus preparing an aluminum support. The amount of silicate attached was 3.6 mg/m².

### Formation of lower layer

The surface of aluminum support 2 prepared as above was coated with an undercoat layer coating liquid having the composition below at a dry coat weight of 10 mg/m² and dried at 100°C for 1 min to thus form a lower layer.

### Undercoat layer coating liquid

| | |
|---|---|
| Undercoat compound (1) above | 1 part |
| Methanol | 1,000 parts |

### Formation of Photosensitive layer

Subsequently, photosensitive layer coating liquid 4 having the composition below was applied by means of a bar coater and dried in an oven at 70°C for 60 sec, thus forming a photosensitive layer with a dry coat weight of 1.0g/m².

### Photosensitive Layer Coating Liquid 4

| | |
|---|---|
| Binder polymer (4) (P-29, average molecular weight) below | 0.50 parts |
| 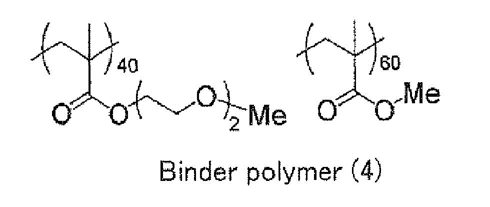 | |
| Polymerizable compound (EO-modified isocyanurate triacrylate, Aronix M-315, TOAGOSEI Co., Ltd.)) | 1.15 parts |
| Polymerization initiator (2) blow | 0.20 parts |
| 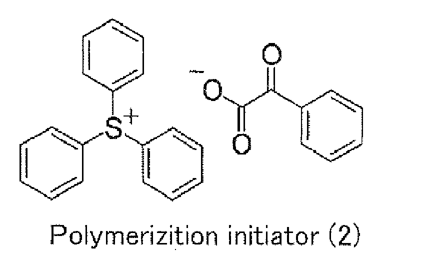 | |
| IR absorber (1) below | 0.05 parts |
| 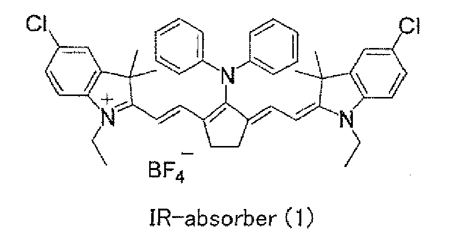 | |
| Microcapsule liquid (1) below | 2.00 parts |
| Fluorine-based surfactant (1) above | 0.05 parts |
| Crystal violet naphthalene sulfonic acid | 0.04 parts |
| 1-Methoxy-2- propanol | 18.00 parts |
| Compound shown in Table 5 | 0.05 parts |

### Synthesis of Microcapsule Liquid (1)

As an oil phase component, 10 parts by weight of an adduct of trimethylolpropane and xylene diisocyanate (Takenate D-110N, Mitsui Chemicals, Inc.), 3.15 parts by weight of pentaerythritol triacrylate (SR444, Sartomer Company Inc.), 0.35 parts by weight of IR absorber (2) below, and 0.1 parts by weight of Pionin A-41C (Dodecylbenzenesulfonicacid calcium, Takemoto Oil & Fat Co., Ltd.) were dissolved in 17 parts by weight of ethyl acetate. As an aqueous phase component, 40 parts by weight of a 4 wt % aqueous solution of PVA-205 was prepared. The oil phase component and the aqueous phase component were mixed and emulsified using a homogenizer at 12,000 rpm for 10 min. The resulting emulsion was added to 25 parts by weight of distilled water and the mixture was stirred at room temperature for 30 min and then stirred at 40°C for 3 hours. Microcapsule liquid (1) thus obtained was diluted with distilled water so as to have a solids content concentration of 20 wt %. The average particle diameter of the microcapsules was 0.3 µm.

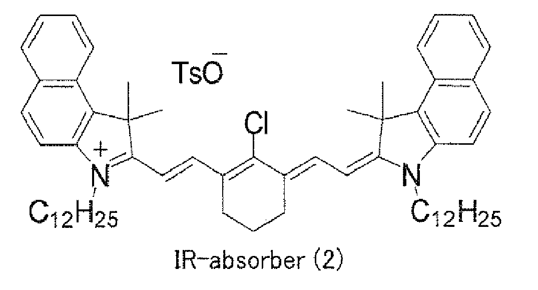

### Formation of protective layer

A protective layer was provided by coating the top of the photosensitive layer with protective layer coating liquid (2) above at a dry coat weight of 0.5 g/m², and drying it at 100°C for 1 min, thus giving lithographic printing plate precursors (30) to (34).

Lithographic printing plate precursors (30) to (34) thus obtained were exposed using a Trendsetter 3244VX (Creo) equipped with a water-cooled 40 W IR semiconductor laser (wavelength 830 nm) under conditions of an output of 9 W, a resolution of 2,400 dpi, and a standard exposure of 150 mJ/cm² and then developed in the same manner as in Example 1. The results are shown in Table 5 (exposure was carried out by changing the exposure for sensitivity evaluation).

**(Table 5)**

| Ex. Comp. Ex. | Lithographic printing plate precursor | | | | Result of evaluation | | | | | |
|---|---|---|---|---|---|---|---|---|---|---|
| | No. | Compound | | | Sensitivity (µJ/cm²) | Developability (cm/min) | Staining properties | | Plate life | |
| | | No, | Dipole moment (debye) | Log P | | | Standard (point) | Post- heated (point) | Standard (× 10⁴ sheets) | Post-heated (× 10⁴ sheets) |
| Ex. 24 | (30) | C-D1 | 4.72 | -1.55 | 130 | 130 | 10 | 10 | 5.5 | 6.5 |
| Ex. 25 | (31) | C-03 | 7.31 | -0.31 | 110 | 110 | 10 | 10 | 8.0 | 9.0 |
| Ex. 26 | (32) | C-21 | 8.68 | -1.05 | 100 | 130 | 10 | 10 | 9.0 | 10.0 |
| Ex.27 | (33) | C-27 | 5.69 | 0.86 | 120 | 100 | 10 | 10 | 6.0 | 7.0 |
| Comp. Ex. 7 | (34) | - | 0.00 | 0.00 | 150 | 80 | 9 | 9 | 4.0 | 5.0 |

## Claims

1. A lithographic printing plate precursor having provided on or above a support a photosensitive layer comprising at least
a polymerizable compound,
a photopolymerization initiator,
a binder polymer, and
at least one compound, represented by any of Formulae (1) to (5), having at least one hydrophilic group and a molecular weight of no greater than 1,500: 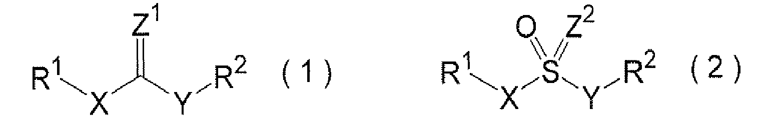 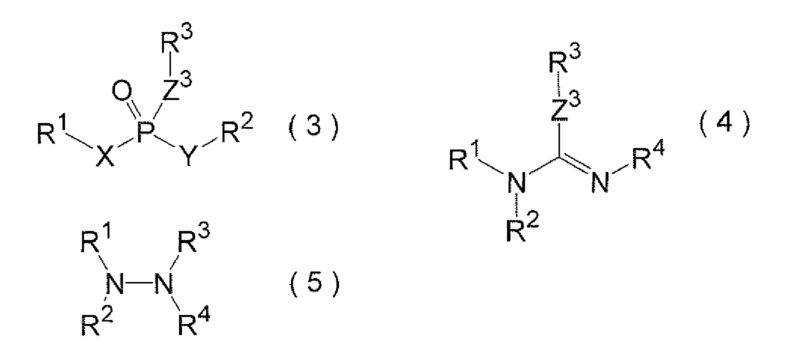 (in Formulae (1) to (5), X and Y independently denote a single bond, an oxygen atom, a sulfur atom, -C(R⁵)(R⁶)-, or -N(R⁵)-, Z¹ denotes an oxygen atom or a sulfur atom, Z² denotes an oxygen atom or a lone electron pair, Z³ denotes a single bond, an oxygen atom, a sulfur atom, -C(R⁵)(R⁶)-, or -N(R⁵)-, and R¹ to R⁶ independently denote a monovalent substituent comprising at least one type of atom selected from the group consisting of a hydrogen atom, a carbon atom, an oxygen atom, a nitrogen atom, a sulfur atom, a phosphorus atom, a halogen atom, and a silicon atom, any two or more of R¹ to R⁶ may be bonded to each other to form a ring, or R¹ to R⁶ may form a double bond together with X, Y, or Z³).

2. The lithographic printing plate precursor according to Claim 1, wherein the hydrophilic group is selected from the group consisting of an acid group, an amide group, an alkylene oxide group, an ammonium group, a hydroxy group, and a sulfonamide group.

3. The lithographic printing plate precursor according to Claim 1 or 2, wherein the compound represented by Formulae (1) to (5) above has a dipole moment of at least 3.8 Debye, preferably at least 4.0 Debye.

4. The lithographic printing plate precursor according to any one of Claims 1 to 3, wherein the compound represented by Formulae (1) to (5) above has a Log P value of less than 1, preferably less than 0.75.

5. The lithographic printing plate precursor according to any one of Claims 1 to 4, wherein the photosensitive layer further comprises a sensitizing dye.

6. The lithographic printing plate precursor according to any one of Claims 1 to 5, wherein it comprises a protective layer above the photosensitive layer.

7. A process for producing a lithographic printing plate, comprising
an exposure step of imagewise exposing with a laser the lithographic printing plate precursor according to any one of Claims 1 to 6, and
a development step of removing the photosensitive layer of a non-exposed portion in the presence of an aqueous developer having a pH of 2 to 11.

8. The process for producing a lithographic printing plate according to Claim 7, wherein it comprises, subsequent to the exposure step and prior to the development step, a step of heating the lithographic printing plate precursor to 100°C or greater.

9. The process for producing a lithographic printing plate according to Claim 7 or 8, wherein the development step is a step of carrying out using a single liquid removal of the protective layer, development, and a gumming treatment.

10. A lithographic printing plate produced by the process for producing a lithographic printing plate according to any one of Claims 7 to 9.
